**Europäisches Patentamt**

**European Patent Office**

**Office européen des brevets**

(11) Veröffentlichungsnummer: **0 421 931 A1**

# (12) EUROPÄISCHE PATENTANMELDUNG

(21) Anmeldenummer: **90810740.2**

(22) Anmeldetag: **27.09.90**

(51) Int. Cl.⁵: **H05K 13/00**

(30) Priorität: **06.10.89 CH 3650/89**

(43) Veröffentlichungstag der Anmeldung:
**10.04.91 Patentblatt 91/15**

(84) Benannte Vertragsstaaten:
**AT BE CH DE FR GB IT LI NL SE**

(71) Anmelder: **CIBA-GEIGY AG**
**Klybeckstrasse 141**
**CH-4002 Basel(CH)**

(72) Erfinder: **Martin, Peter, Dr.**
**Gerbergässlein 18**
**CH-4051 Basel(CH)**

(54) **Transportvorrichtung für Platten, insbesondere mit empfindlicher Oberfläche.**

(57) Eine Transportvorrichtung (1) für Platten (2) oder plattenförmige Werkstücke, insbesondere mit empfindlicher Oberfläche, vorzugsweise für Leiterplatten, die mit Kunststoff, z.B. UV-härtbarem Kunststoff, mit Lack oder dergleichen beschichtet und dann getrocknet werden, ist als Umlaufbeschichtungsanlage ausgebildet. Dabei enthält die Vorrichtung (1) vor allem Halter (3) zum Erfassen der Platten (2) an den Plattenrändern (2a) bei deren Handhabung und zweckmäßigerweise als Ketten (4) ausgebildete Vorschubmittel zum Transport dieser Halter (3). Der Halter (3) hat zwei parallele Holme (10), an denen jeweils zwei Reihen (11, 12) von rechenförmig angeordneten Zinken (13) vorgesehen sind, wobei die Zinken (13) der einen Reihe (11) eines Holmes (10) mit denen der zweiten Reihe (12) dieses Holmes (10) einen spitzen Winkel einschließen und also die beiden Reihen (11, 12) im Querschnitt gesehen V-förmig zueinander angeordnet sind. Die freien Enden der Zinken (13) des einen Holmes (10) sind dabei gegen die freien Enden der Zinken (13) des anderen Holmes (10) gerichtet. Die beiden Holme (10) gehen von einem gemeinsamen, sie haltenden und verbindenden Träger (14) aus, an welchem auf der Seite, an der die Holme (10) abgehen, ein stirnseitiger Anschlag (15) für die Platten (2) vorgesehen ist, der zwei unter einem stumpfen Winkel zueinander stehende, zu den Holmen (10) verlaufende Schenkel (15a, 15b) hat, so daß eine sich abstützende Rechteck-Platte nur mit ihren diesem Anschlag (15) zugewandten Ecken anstößt

Fig. 1

# TRANSPORTVORRICHTUNG FÜR PLATTEN INSBESONDERE MIT EMPFINDLICHER OBERFLÄCHE

Die Erfindung betrifft eine Transportvorrichtung für Platten oder plattenförmige Werkstücke, insbesondere mit empfindlicher Oberfläche, vorzugsweise für Leiterplatten, die mit Kunststoff, z.B. UV-härtbarem Kunststoff, mit Lack oder dergleichen beschichtet und dann getrocknet werden, wobei die Vorrichtung Halter zum Erfassen der Platten an den Plattenrändern bei ihrer Handhabung und Vorschubmittel zu ihrem Transport zu und durch Bearbeitungsstationen aufweist.

Es sind unterschiedliche Vorrichtungen zum Halten und für den Transport von Platten oder plattenförmigen Werkstücken bekannt, die berücksichtigen sollen, daß die Oberflächen der Platten geschont werden. Dies ist vor allem dann notwendig, wenn naßbeschichtete Leiterplatten von der Beschichtungs- in die Trockenstationen befördert werden sollen. Solche Leiterplatten werden nämlich mit einem Schutzlack beschichtet, der zunächst getrocknet, dann belichtet und an den unbelichteten Stellen heraus entwickelt wird.

Nach dem Beschichten müssen solche Platten gelüftet und getrocknet werden. Dabei besteht ein weiteres Pro blem darin, daß in der Regel beide Oberflächen einer solchen Platte beschichtet und entsprechend behandelt werden müssen, wobei während der Beschichtung der zweiten Oberfläche die auf der ersten Oberfläche befindliche Schicht nicht ausgehärtet, also verletzungsempfindlich ist.

Aus der FR-A-2 439 734 ist eine Transportvorrichtung für Leiterplatten mit gedruckten Schaltungen bekannt, die einen Endlosförderer mit Kettenantrieb hat, wobei die Platten im Bereich des Obertrums dieses Förderelementes in nach oben offenen Schlitzen stecken, so daß ihre Oberflächen etwa vertikal orientiert sind. Dabei wird jeweils nur ein Plattenlängsrand umfaßt. Eine solche Fördervorrichtung wäre für frisch beschichtete Platten ungeeignet, weil dann die Beschichtungsflüssigkeit mindestens teilweise an der Oberfläche ablaufen würde und Spuren und Tränen bilden könnte.

Aus der EP-A-312,498 ist eine Transportvorrichtung der eingangs genannten Art bekannt, bei welcher als Halter Greifer oder Klammern vorgesehen sind, die ein lösbar kuppelbares Halteelement haben, das jeweils an den Übergängen von einem Vorschubmittel zu einem anderen oder von einer Bearbeitungsstation zur anderen zusammen mit der gehaltenen Platte umsetzbar oder umladbar ist.

Dadurch lassen sich zwar die Platten schonend in einem beschichtungsfreien Randbereich erfassen und können während der gesamten Bearbeitung mit ihren Haltern verbunden bleiben, jedoch ist ein hoher maschineller und Steuerungstechnischer Aufwand erforderlich, um einen kontinuierlichen Betrieb einer entsprechenden Transportvorrichtung zu gewährleisten. Vor allem das beidseitige Beschichten solcher Platten erfordert zwei hintereinander angeordnete Belackungsstationen, zwischen denen eine gesonderte Trocknungsstation eingeschaltet sein muß, damit zunächst die erste Beschichtung eine genügende Festigkeit erhält, um das Weiterbefördern der Platte zu der zweiten Belackungsstation zu erlauben. Darüber hinaus muß Vorsorge dafür getroffen werden, daß die Halter für die Platten immer rechtzeitig ein- und ausgekuppelt und nach Durchlaufen der gesamten Transportvorrichtung wieder an den Ausgangspunkt zurücktransportiert werden können, um dort weitere Platten aufnehmen zu können.

Es besteht deshalb die Aufgabe, eine Transportvorrichtung der eingangs erwähnten Art zu schaffen, bei welcher der Vorteil erhalten bleibt, daß die Halter lediglich an unbeschichteten Stellen der Platten angreifen, aber der konstruktive und herstellungstechnische Aufwand sowie die Handhabung dieser Halter vereinfacht ist und die Halter die Möglichkeit eröffnen, die gesamte Transportvorrichtung zu vereinfachen und in ihrem Platzbedarf zu vermindern.

Die Lösung dieser Aufgabe besteht im wesentlichen darin, daß der Halter wenigstens zwei parallele Holme hat, an denen jeweils zwei Reihen von rechenförmig angeordneten Zinken vorgesehen sind, wobei die Zinken der einen Reihe eines Holmes mit denen der zweiten Reihe dieses Holmes einen spitzen Winkel einschließen und also die beiden Reihen im Querschnitt gesehen V-förmig zueinander angeordnet sind und wobei die freien Enden der Zinken des einen Holmes etwa gegen die freien Enden der Zinken des anderen Holmes gerichtet sind, daß der zu der Längsmittelebene zwischen den beiden parallelen Holmen zunehmende lichte Abstand zwischen den Zinkenreihen wenigstens über einen Teil des zwischen den Holmen befindlichen Bereiches größer als die Dicke einer zu haltenden Platte ist, daß die beiden Holme an einem ihrer Enden einen sie haltenden und verbindenden Träger aufweisen und daß an diesem Träger ein stirnseitiger Anschlag für Platten vorgesehen ist, der etwa von der Mitte des Trägers ausgehend zwei unter einem stumpfen Winkel zueinander stehende, zu den Holmen verlaufende Schenkel hat.

In einen solchen Halter kann eine auch auf einer Oberfläche bis auf zwei parallel zu den Holmen verlaufende schmale Längsrandbereiche beschichtete Platte eingelegt werden, ohne daß die Beschichtung durch die Auflagerung der Platte beeinträchtigt wird. Die Verwendung von Zinken und zwei parallelen Holmen, die von einem gemeinsamen Träger ausgehen, erlaubt dabei das Einführen von derjenigen Stirnseite des Halters her, die dem Träger gegenüberliegt. Auch ein Anheben und Absetzen innerhalb des Halters ist aufgrund der Auflager-Zinken problemlos möglich, weil entsprechende Gegen-Zinken oder sonstige beabstandete Tragelemente durch die Zwischenräume der Zinken "abtauchen" oder angehoben werden können. Der stirnseitige Anschlag sorgt dabei dafür, daß auch bei einer Verstellung des Halters aus seiner horizontalen Position, in der auch die Holme horizontal angeordnet sind, in eine vertikale Position mit von dem Träger aufwärts gerichteten Holmen die Platte sich mit einem beschichtungsfreien Bereich, nämlich jeweils der vordersten Ecke, die zwischen der Plattenstirnseite und dem Lackfreien Längsrandbereich angeordnet ist, an den Schenkeln des stirnseitigen Anschlages abstützen kann.

Somit sind durch diesen Halter und seine Merkmale alle Voraussetzungen dafür geschaffen, eine Platte einfach in den Halter einlegen, innerhalb des Halters transportieren zu können, selbst wenn sie schon auf beiden Seiten beschichtet ist, und auch wieder entnehmen zu können, ohne daß die belackten Mittelbereiche in irgendeiner Weise mit dem Halter in Berührung kommen.

Die gute Einführbarkeit und Entnehmbarkeit der Platten in und aus dem Halter erlaubt ferner, daß der Halter mit seinem Vorschubmittel verbunden bleiben kann und an den Übergabestationen kein Abkuppeln von dem Fördermittel und Ankuppeln an den nächsten Fördermittel erforderlich wird, wodurch der Aufwand bei der Handhabung der Halter vermindert wird.

Da schließlich der Halter aufgrund der beiden Zinkenreihen auch um 180° gewendet die übereinstimmende Funktion erfüllen kann, kann der Transport einer Platte gewissermaßen im Umlauf aufwärts, horizontal und wieder abwärts erfolgen, wodurch der Halter und die Platte gleichzeitig gewendet werden, so daß die besondere Halterform die Möglichkeit eröffnet, eine Platte nach Verlassen einer Belackungsstation zunächst in der schon erwähnten Weise aufwärts zu transportieren, wobei sie zunächst horizontal orientiert bleibt, so daß ein erstes Trocknen erfolgen kann. Nun erfolgt das Wenden der Platte über einen horizontalen und einen wieder abwärts gerichteten Förder-Strang, wobei die Platte gleichzeitig wieder in Vorschubrichtung vor die Belackungsstation gebracht werden kann. Sie kann dann also für die Beschichtung der zweiten Oberfläche durch dieselbe Belackungsstation geführt werden, so daß die gesamte Anlage nur eine einzige Belackungsstation benötigt und gleichzeitig in ihrer Längenausdehnung erheblich vermindert wird.

Besonders zweckmäßig ist es, wenn der lichte Abstand zwischen den V-förmig zueinander angeordneten Zinkenreihen unmittelbar an oder neben dem jeweiligen Holm kleiner, an einer Übergangsstelle gleich und benachbart dazu - näher zur Längsmittelebene des Halters -größer als die Plattendicke ist. Dadurch wird sichergestellt, daß rechteckige Platten in einem mittleren Bereich des Halters eingelegt werden können, ohne seitlich zu den Holmen verschoben werden zu können. Selbst wenn eine seitliche Verschiebung aufgrund einer relativ geringen Dicke der Platte und auch bei einer relativ geringen Breite der Platte möglich ist, kann sie außerdem immer nur mit ihren Längskanten in Berührkontakt zu den Zinken gelangen, so daß die Oberfläche nicht berührt wird und auf keinen Fall der Bereich der Oberfläche, der in geringem Abstand zu der Seitenkante beschichtet werden soll. Außerdem ergibt sich durch diese geometrische Anordnung die Möglichkeit, unterschiedlich breite und lange Platten sowie auch unterschiedlich dicke Platten einlegen zu können.

Die einzelnen Zinken einer Reihe sind zweckmäßigerweise jeweils parallel zueinander und rechtwinklig zu dem Holm angeordnet und jeweils zwei unter einem spitzen Winkel etwa von derselben Stelle des Holmes ausgehende Zinken können dabei in einer rechtwinklig zu der Erstreckung des Holmes angeordneten Ebene liegen. Zwar wäre auch ein gegenseitiger Versatz der Zinken der beiden Reihen eines Holmes denkbar, jedoch hat die vorerwähnte Ausgestaltung den Vorteil, daß zwischen den Zinken auf- und abwärts bewegbare Fördermittel auf diese Weise von beiden Seiten her in gleicher Weise und an gleicher Stelle angeordnet sein können.

Die Ausnutzung des Halters auch in umgewendeter Position wird erleichtert und gefördert, wenn die beiden Holme mit ihren V-förmig angeordneten, gegeneinander gerichteten Reihen von Zinken spiegelsymmetrisch zu der zwischen den Holmen verlaufenden Längsmittelebene angeordnet sind. Dabei stimmen die Winkelhalbierenden der von den Zinken des einen Holmes jeweils gebildeten spitzen Winkel mit denen der von den Zinken des anderen Holmes gebildeten Winkeln zweckmäßigerweise überein, so daß sich letztlich auch zu einer durch diese Winkelhalbierenden aufgespannten Ebene eine Symmetrie ergibt.

Die Winkelhalbierenden können dabei mit den Holmen in einer gemeinsamen Ebene liegen, zu der die Längsmittelebene rechtwinklig angeordnet ist.

Damit das Ein- und Ausbringen der Platten an dem Halter möglichst einfach durchführbar ist, kann der Abstand zwischen jeweils einander in Reihe benachbarter Zinken größer als die seitliche Ausdehnung dieser Zinken sein, z.B. das Fünffache bis Zehnfache, insbesondere das Siebenfache oder Achtfache des Zinkendurchmessers oder der Zinkenbreite betragen.

Zwischen den freien Enden der einander vorzugsweise genau in einer gemeinsamen Ebene gegenüber liegenden Zinken eines Halters kann ein Zwischenraum vorgesehen sein, der kleiner ist, als es der geringsten Breite einer Leiterplatte entspricht, und die Abmessung dieses Zwischenraumes kann vorzugsweise etwa ein Sechstel bis ein Viertel, insbesondere ein Fünftel des Abstandes der beiden parallelen Holme betragen. Einerseits werden da durch die Platten genügend sicher an ihren Rändern gehalten, andererseits kann jedoch ein Übergabe-Mittel in den Halter eingeführt werden, dessen Zinken oder - bei einem noch zu beschreibenden Rollenförderer - Rollen von einem durch diesen Zwischenraum zwischen den Zinken des Halters passenden Träger gehalten sind.

Zur Anpassung an unterschiedliche Plattengrößen kann der Abstand der Holme des Halters zueinander verstellbar sein.

Ausgestaltungen des stirnseitigen Anschlages, an welchem sich eine Platte abstützen kann, wenn die Holme des Halters schräg oder senkrecht nach oben stehen, was während eines Transport-Umlaufes wichtig ist, sind Gegenstand der Ansprüche 10 - 13. Insbesondere ergibt sich durch diese Merkmale und Maßnahmen auch eine geometrische Anpassung des stirnseitigen Anschlages und seiner Schenkel an die durch die Zinken gebildete Umriß- oder Querschnittsform des Halters. Dadurch wird einerseits sichergestellt, daß eine Platte auch bei vertikaler Orientierung des Halters und seiner Holme nicht an dieser Stirnseite herausrutschen kann, dennoch aber vermieden, daß dieser stirnseitige Anschlag im Bereich der Holme die größte Breite, die an den freien, einander zugewandten Enden der Zinken erforderlich ist, beibehält.

Der Träger kann die beiden von ihm abgehenden parallelen Holme beidseits überragen, d.h. sich über die Befestigungsstellen der Holme hinaus fortsetzen und insbesondere in dem Bereich des Überstandes Befestigungs- oder Kupplungsstellen, z.B. Lochungen, zum Verbinden mit Vorschubmitteln für den Transport der Halter und der Platten aufweisen. Dadurch befinden sich dann diese Befestigungsstellen in einem relativ großen Abstand zueinander, was auch zu einer stabilen Fixierung des Halters an einem entsprechenden Vorschubmittel beiträgt.

Als Vorschubmittel für eine Vielzahl von in gleichbleibendem Abstand zueinander daran angeordnete Halter kann ein endlos umlaufendes Zugelement - also ein in Zugrichtung Kräfte übertragendes, in Druckrichtung aber nicht oder nur begrenzt Kräfte aufnehmendes Element, vorzugsweise Ketten, Bänder od. dgl. vorgesehen sein, zu dessen Längserstreckung und Bewegungsrichtung die Holme der Halter etwa rechtwinklig nach außen abstehen, wobei die freien, dem Träger abgewandten Enden der Holme von den Zugelementen oder Ketten weggerichtet sind. Dies ermöglicht ein bequemes Zuführen und Entnehmen der Platten insbesondere dann, wenn das Zugelement eine vertikale und damit der Halter und seine Holme eine horizontale Lage einnehmen.

Damit die Halter an ihrem Vorschubelement verbleiben können, also auch an dessen Untertrum problemlos weiterlaufen können, ohne daß dort die Platten herausfallen, und damit vorallem die Platten - falls gewünscht - auf ihren beiden Seiten beschichtet werden können, sieht eine Ausgestaltung der eingangs genannten Vorrichtung von eigener schutzwürdiger Bedeutung vor, daß seitlich bzw. in horizontaler Richtung quer zur Vorschubrichtung neben dem endlos umlaufenden Vorschubmittel mit daran befestigten oder angekuppelten Haltern eine Beschichtungs- oder Belackungsstation angeordnet ist und daß jeweils in einem eine vertikale Vorschubrichtung aufweisenden Förderbereich des umlaufenden Vorschubmittels - wie vorstehend als Möglichkeit bereits angedeutet - Übergabestationen, vorzugsweise Rollenbahnen mit jeweils V-förmig zueinander angeordneten Rollenpaaren mit antreibbaren Rollen zum Entnehmen der Platten aus den Haltern und außerhalb des von den Haltern durchlaufenden Bereiches Querförderer vorgesehen sind, mit denen die Platten oder Leiter platten seitlich versetzt und der Beschichtungs- oder Belackungsstation zuführbar und nach dem Beschichten oder Lackieren in umgekehrter Weise einer Übergabestation und dort einem Halter zuführbar sind. Aus der vorangegangenen Beschreibung des Halters selbst und den vorstehend genannten Merkmalen ergibt sich also insgesamt eine Vorrichtung, bei welcher eine einzige Beschichtungsstation mehrfach mit denselben Platten beschickt werden kann, wobei diese immer wieder aus einem Halter entnommen, beschichtet und wieder einem Halter des Vorschubmittels zugeführt werden können. Dabei wirkt zusammen, daß Entnahme und Beschickung des Halters sehr einfach sind, weil die Abstände zwischen den Zinken einen bequemen Eingriff in den Halter mit vergleichbaren Gabeln oder Abstände zwischen sich aufweisenden Rollen erlauben. Die V-Form der Rollenanordnung bewirkt dabei, daß die Platten auch auf diesen Übergabemitteln nur an den Kanten ihrer Längsränder berührt werden.

Als Querförderer - für die Überbrückung des seitlichen Versatzes der Belackungsstation gegenüber dem endlos umlaufenden Vorschubmittel - können querfördernde, zwischen die Rollen der Rollenbahnen passende und in den Zwischenräumen zwischen den Rollen unter das Rollenniveau absenkbare und über das Rollenniveau anhebbare Hubbänder vorgesehen sein, deren Fördertrum bis zwischen die Rollen eines vor undoder hinter der Belackungsstation angeordneten - weiteren - Rollenförderers reichen. Es wird also auch bei diesem Querförderer wiederum ausgenutzt, daß die Platten auf Einzelelementen, in diesem Falle Rollen eines Rollenförderers, liegen, die Abstände zwischen sich haben, was bei dem Rollenförderer zunächst den Vorteil hatte, daß er zwischen die Zinken des Halters paßt, nun aber außerhalb des Halterbereiches auch das Unterbringen von Querförderbändern ermöglicht.

Falls unerwünscht ist, daß Querförderbänder die Platten an ihrer in dieser Situation an der Unterseite über die gesamte Plattenbreite beaufschlagen, kann eine abgewandelte Ausgestaltung vorsehen, daß als Querförderer mit ihren Zinken zwischen die einzelnen Rollen der Rollenbahnen an der Übergabestation und an der Belackungsstation passende Hub- und Schwenkrechen vorgesehen sind, die an einer zwischen diesen beiden parallelen Rollenbahnen angeordneten Hubsäule angeordnet, unter das Niveau der Rollen absenkbar und über das Niveau der Rollen anhebbar und in angehobener Position um wenigstens 180° um eine vertikale Achse verdrehbar sind und daß die Zinken vorzugsweise in ihrer Längsrichtung konkav gekrümmt oder unter einem stumpfen Winkel gebogen sind, so daß sie in ihrer Gesamterstreckung ähnlich den einander gegenüberliegenden und mit ihren Enden gegeneinander weisenden Zinken des Halters geformt sind. Somit wird auch auf diesem Schwenkrechen eine Platte jeweils nur mit den Kanten ihrer Längsränder aufliegen.

Der Hub- und Schwenkrechen kann dabei auch ein Doppelrechen sein, bei welchem von einem an der Hub- und Schwenksäule angeordneten Tragprofil nach den beiden einander gegenüberliegenden Seiten in vorzugsweise symmetrischer Anordnung Zinken abstehen, die jeweils in die Zwischenräume der Rollen der Rollenbahnen reichen. Somit braucht zur Übergabe der Schwenkrechen nur einmal um 180° verdreht zu werden, wonach er bereits für die nächste Übergabe wieder betriebsbereit ist, ohne daß er wieder zurückgedreht oder -geschwenkt wird.

Die innerhalb der Rollenbahnen jeweils unter stumpfem Winkel V-förmig zueinander geneigten Rollen können auf einer entsprechend V-förmigen Achse oder V-förmig angeordneten Achsenstücken gelagert sein, wobei eine der beiden Rollen angetrieben und die andere mit der angetriebenen Rolle über ein elastisches Verbindungselement, insbesondere einespiralfeder, in Drehrichtung gekuppelt sein kann. Auf diese Weise sind die V-förmig zueinander geneigten Rollen eines Rollenpaares beide durch einen Antrieb in Drehung zu versetzen, um eine untergriffene Platte aus einem Halter heraus oder in einen Halter hinein bewegen zu können.

Der Neigungswinkel der V-förmig angeordneten Transportrollen sowie der Zinken des Hub- und Schwenkrechens und die Neigungswinkel der von den beiden Holmen insbesondere geradlinig aufeinander zulaufenden Zinken können etwa miteinander übereinstimmen, so daß eine in der Vorrichtung transportierte und behandelte Platte an all diesen Elementen übereinstimmende Auflageverhältnisse vorfindet.

Es ist zweckmäßig, wenn das Vorschubelement taktförmig weiterbewegbar ist und jeweils ein Halter an der Übergabestation zu der Belackungsstation und in der Übergabestation von der Belackungsstation wieder zurück im Bereich der ab- und zuführenden Rollenbahnen angeordnet ist, wobei die Eingabe- und Ausgabemittel ortsfest und bezüglich ihres Niveaus unveränderlich angeordnet sein können. Dadurch kann das Übergeben und Übernehmen an den beiden Stationen praktisch gleichzeitig erfolgen. Während nämlich das abwärtsführende Trum die in dem Halter befindliche Platte auf der Rollenbahn zum Entnehmen aus dem Halter ablegt, gelangt ein weiterer leerer Halter von unten her durch die Zwischenräume der Rollenbahn an der Übernahmestation mit seinen Zinken durch die Abstände der Rollen hindurch und kann eine dort hin beförderte Platte abheben und im weiteren Transportverlauf mitnehmen.

Es wäre denkbar, mit der erfindungsgemäßen Vorrichtung nach dem Beschichten beider Seiten der Platte weitere Schichten aufzutragen, falls z.B. auf einer oder mehreren Plattenseiten mehr als eine Schicht benötigt würde. In der Regel ist jedoch nur eine einmalige Beschichtung jeder Plattenseite erwünscht, wonach die Platte den Transportzyklus verlassen soll. Um dies weitgehend automatisch bzw. selbsttätig zu erreichen, kann eine Ausgestaltung der Erfindung darin bestehen, daß an der Übergabestation zu der Belackungsstation zusätzlich eine Ausgabevorrichtung für beschichtete Platten und vorzugsweise eine Sensoreinrichtung, insbesondere eine optische Sensoreinrichtung angeordnet ist, die die Entlade- oder Ausgabevorrichtung ansteuert, wenn eine Platte beidseitig beschichtet ist, und die die Übergabevorrichtung zu der Belackungsstation ansteuert, wenn die Platte einseitig beschichtet ist. Dies kann auf einfache Weise dadurch geschehen, daß bei Feststellung, daß eine Platte beidseitig beschichtet ist, der Querförderer, also die querfördernden Hubbänder oder der Schwenkrechen ausgeschaltet bleiben, so daß die von dem Vorschubmittel für die Halter wegführende Rollenbahn die Platte einfach weiterbefördern kann. Andernfalls wird der Antrieb dieser Rollenbahn stillgesetzt, wenn die Platte den Bereich des Querförderers erreicht hat, um dann auf den Rollenförderer vor der Belackungsstation umgesetzt zu werden.

Der Förderweg der Platten von der Belackungsstation weg und wieder zu der Belackungsstation hin mit der dabei erfolgenden Umwendung der Platte wird gleichzeitig dazu ausgenutzt, die frische Beschichtung soweit zu trocknen, daß sie nicht mehr beschädigt werden kann.

Dazu ist zweckmäßigerweise vorgesehen, daß der aufwärts, insbesondere vertikal aufwärts führende Bereich des Vorschubelementes, der sich in Förderrichtung hinter der Belackungsstation befindet, eine Zuluft- und Absaugeinrichtung zum Belüften und Vortrocknen der beschichteten Platten aufweist.

Ein Teil des Förderweges des Vorschubelementes kann als Trocknungsstation ausgebildet sein, vorzugsweise der sich an den aufwärts gerichteten Teil anschließende, insbesondere horizontal und entgegengesetzt zur Förderrichtung in der Belackungsstation bewegbare Teil des Vorschubmittels. In diesem Bereich stehen die Halter und die von ihnen erfaßten Platten etwa vertikal, was jedoch deshalb unschädlich ist, weil zuvor eine Vortrocknung stattgefunden hat.

Der in Förderrichtung im Anschluß an die Trocknungsstation angeordnete, vorzugsweise wieder abwärts, insbesondere vertikal abwärts zu der Ausgabestation und Übergabestation führende Teil des Vorschubelementes kann als Kühl- und Nachtrocknungsstrecke ausgebildet sein, an deren Ende die Entnahmevorrichtung und ggf. der Sensor angeordnet sind.

Die Halter des Vorschubelementes an dessen zwischen der abwärts gerichteten Förderstrecke und der aufwärts gerichteten Förderstrecke befindlichen, parallel zu dem Förderweg in der Belackungsstation bewegbaren Untertrum sind also leer, da die Platten vor der Umlenkung in dieses Untertrum bereits entnommen ,werden und erst nach der weiteren Umlenkung wieder eingebracht werden.

Weitere Ausgestaltungen der Vorrichtung, insbesondere auch der Belackungsstation sowie ihrer Fördermittel zum Bewegen der Platten mit der entsprechenden Geschwindigkeit durch die Belackungsstation hindurch, die auf die getaktete Vorschubgeschwindigkeit an dem Vorschubmittel abgestimmt ist, sind Gegenstand weiterer Ansprüche.

Nachstehend sind zwei Ausführungsbeispiele einer erfindungsgemäßen Vorrichtung anhand der Zeichnung näher beschrieben. Es zeigt in z.T. schematisierter Darstellung:

Fig. 1 eine Ansicht eines Halters mit zwei von einem gemeinsamen Träger ausgehenden parallelen Holmen, die gegeneinander gerichtete Reihen von Trag-Zinken für rechteckige Platten aufweisen,

Fig. 2 eine Stirnansicht des Halters gemäß Fig.1 mit Blick auf die Stirnseiten der Holme und der jeweils V-förmig angeordneten Reihen von Zinken an diesen Holmen,

Fig. 3 eine Seitenansicht eines Trägers gemäß Fig. 1 und

Fig. 4 einen Schnitt durch die Längsmittelebene des Halters gemäß der Linie A - A in Fig. 1,

Fig. 5 eine Seitenansicht einer Transportvorrichtung für Platten unter Verwendung des Halters gemäß den Fig. 1 - 4 mit einem endlos umlaufenden Vorschubmittel, an welchem Halter gemäß Fig. 1 - 4 in Vorschubrichtung hintereinander angeordnet sind, wobei parallel zu dem Untertrum des Vorschubmittels mit den Haltern eine Belackungsstation angeordnet ist,

Fig. 6 in vergrößertem Maßstab eine Draufsicht der Transportvorrichtung gemäß Fig. 5 mit an einem endlos umlaufenden Vorschubmittel angeordneten Haltern, Übergabestationen und Verbindungsmitteln zum Überführen der Platten auf die Förderstrecke durch die Belackungsstation einerseits und zum Rückführen der Platte wieder zu dem Vorschubmittel mit Haltern gemäß Fig. 1 - 4,

Fig. 7 eine Seitenansicht des mit Haltern gemäß den Fig. 1 bis 4 bestückten, endlosen Fördermittels sowie den auf gleicher Höhe an zwei einander gegenüberliegenden Stellen im unteren Bereich von vertikalen Förderstrecken angeordneten Ausgabe- bzw. Eingabemitteln,

Fig. 8 eine der Fig. 7 entsprechende Seitenansicht der Belackungsstation und der aus dieser Sicht dahinter angeordneten Transportvorrichtung mit dem umlaufenden Vorschubmittel und den Haltern,

Fig. 9 eine Stirnansicht der gesamten Vorrichtung einschließlich der Belackungsstation,

Fig. 10 eine der Fig. 9 entsprechende Darstellung mit einem Querförderer zum Überführen der Werkstücke nach ihrer Entnahme aus der Trocknungsstation in die Belackungsstation,

Fig. 11 eine der Fig. 6 entsprechende Darstellung mit abgewandelten Mitteln zum Überführen der Werkstücke von der Trocknungsstation zu der Belackungsstation und wieder zurück, nämlich mit Hilfe eines um eine vertikale Achse schwenkbaren Hub- und Schwenkrechens,

Fig. 12 eine der Fig. 10 entsprechende Darstellung der Ausführungsform mit dem Hub- und Schwenkrechen,

Fig. 13 eine vergrößerte Darstellung des Hub- und Schwenkrechens mit seinem Antrieb und

Fig. 14 in separater Darstellung die Anordnung zweier unter einem stumpfen Winkel V-förmig zueinander angeordneter Rollen mit ihrem gemeinsamen Antrieb und einer Verbindungsfeder zur Übertragung des Drehantriebes der einen Rolle auf die zweite.

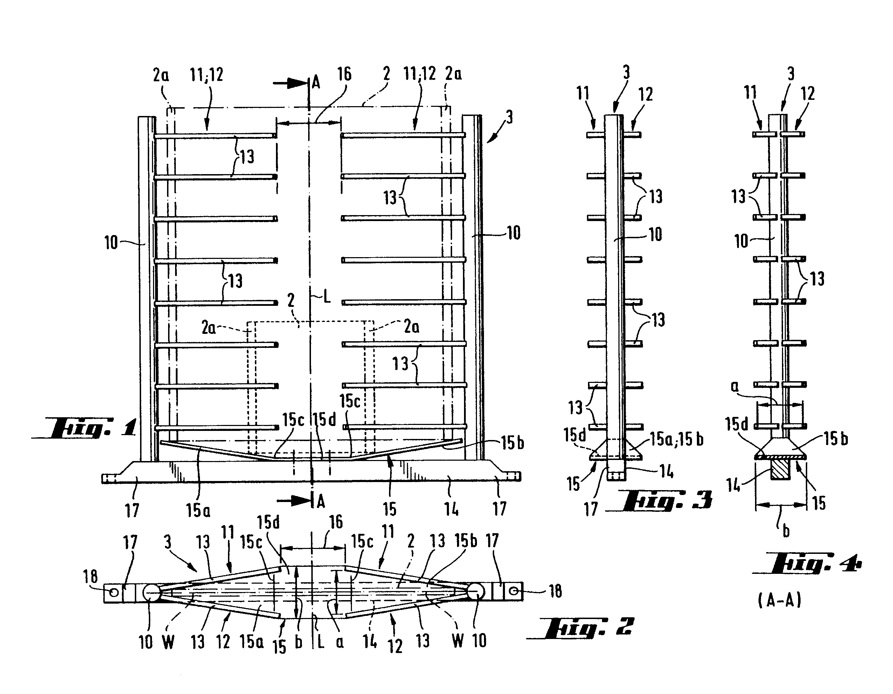

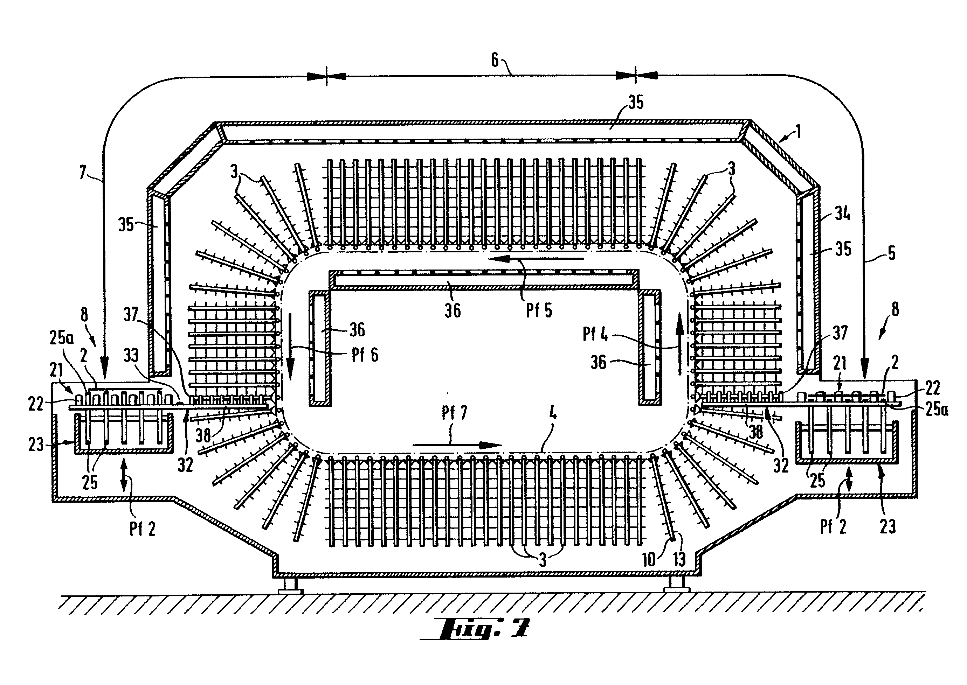

Eine im Ganzen mit 1 bezeichnete, vor allem in den Fig. 5 - 12 jeweils weitgehend dargestellte Transportvorrichtung für Platten 2 oder plattenförmige Werkstücke, insbesondere mit empfindlicher Oberfläche, z.B. für Leiterplatten, die mit Kunststoff oder mit Lack beschichtet und dann getrocknet werden sollen, weist als wesentliche Elemente vor allem die in den Fig. 1 - 4 dargestellten Halter 3 zum Erfassen der Platten 2 an den Plattenrändern bei ihrer Handhabung und verschiedene Vorschubmittel, vor allem ein die Halter 3 ständig aufweisendes Zugele ment, im Ausführungsbeispiel eine endlos umlaufende Kette 4 zum Transport der Halter 3 und der Platten 2 auf, womit diese durch verschiedene noch zu beschreibende Bearbeitungsstationen wie eine Vortrocknungsstation 5, eine Trocknungsstation 6 und eine Kühlstation 7 befördert werden können. Zusätzlich gehören zu der Vorrichtung 1 auch an Übergabestationen 8 befindliche, im folgenden noch näher zu beschreibende Vorschub- oder Fördermittel sowie vor allem die zum Beschichten und Lackieren dienende Belackungsstation 9.

Damit die Platten 2 bei ihrer Handhabung vor allem nach einer Beschichtung an ihrer empfindlichen Oberfläche nicht beschädigt werden können, ist die Ausbildung des Halters 3 in mehrfacher Hinsicht von wesentlicher Bedeutung. Einerseits sollen die Platten bei ihrer Halterung in dem Halter 3 nicht an der beschichteten Oberfläche berührt werden, andererseits muß aber auch ein problemloser Übergang aus und in die Halter 3 möglich sein, um an den Übergabestationen 8 ohne Probleme zu der Belackungsstation 9 und von dieser wieder zurück wechseln zu können.

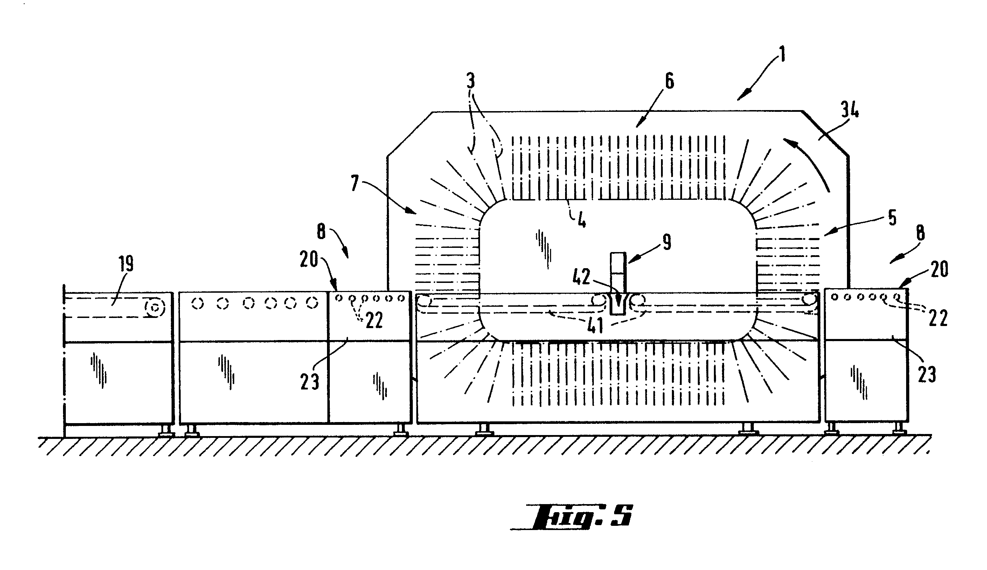

Dazu ist gemäß den Fig. 1 - 4 vorgesehen, daß der Halter 3 zwei parallele Holme 10 hat, an denen jeweils zwei Reihen 11 und 12 von rechenförmig angeordneten Zinken 13 vorgesehen sind. Die Zinken 13 der einen Reihe 11 eines Holmes 10 schließen dabei gemäß Fig. 2 mit denen der zweiten Reihe 12 einen spitzen Winkel ein, d.h., die beiden Reihen 11 und 12 sind - im Querschnitt gesehen - V-förmig zueinander angeordnet. Die freien Enden der Zinken 13 des einen Holmes 10 sind dabei gegen die freien Enden der Zinken 13 des anderen Holmes 10 gerichtet, was man wiederum gut in Fig. 2 erkennt. Der lichte Abstand zwischen den jeweils zu einem Holm 10 gehörenden beiden Zinkenreihen 11 und 12 nimmt also zu der in Fig. 1 und 2 als strichpunktierte Linie L angedeuteten Längsmittelebene zwischen den beiden Holmen 10 zu.

Dabei ist in Fig. 1 und 2 gestrichelt eine Platte 2 angedeutet, wobei in Fig. 1 auch die lackfreien Ränder 2a parallel zu den Holmen erkennbar sind. In Fig. 1 ist dabei gestrichelt eine kleinste Platte 2, die von einem Halter 3 erfaßt werden kann, und strichpunktiert eine größte Platte 2 dargestellt. In Fig. 2 wird dabei deutlich, daß der zur Längsmittelebene L hin zunehmende lichte Abstand zwischen den Zinkenreihen 11 und 12 über einen großen Teil des zwischen den Holmen 10 befindlichen Bereiches größer als die Dicke der zu haltenden Platten 2 ist, so daß die Oberflächen dieser Platten 2 auch bei einem lockeren Liegen auf den Zinken 13 nicht berührt werden.

In den Fig. 1 bis 4 erkennt man ferner, daß die beiden Holme 10 an einem ihrer Enden einen sie haltenden und verbindenden Träger 14 aufweisen und daß an diesem Träger 14 ein stirnseitiger Anschlag 15 für Platten 2 vorgesehen ist, der etwa von der Mitte des Trägers 14 ausgehend zwei unter einem stumpfen Winkel zueinander stehende, zu den Holmen 10 verlaufende Schenkel 15a und 15b hat. Aus Fig. 1 wird erkennbar, daß dadurch die Platten 2 nur mit denjenigen Ecken am Übergang von ihren Stirnseiten zu den Längsschmalseiten mit diesem Anschlag 15 und dessen Schenkeln 15a und 15b in Berührung kommen, an denen die lackfreien Ränder 2a enden, so daß eine Platte 2 an allen mit Teilen des Halters 3 in Berührung kommenden Stellen lackfrei sind, selbst wenn der Halter 3 während des Transportes der Platten 2 aus einer horizontalen Orientierung gemäß Fig. 2 in eine vertikale Lage gemäß Fig. 1 und dann eine umgewendete weitere horizontale Position übergeht und dabei eine in ihm enthaltene Platte 2 umgewendet wird.

Unmittelbar an oder neben dem jeweiligen Holm 10 ist der lichte Abstand zwischen den V-förmig zueinander angeordneten Zinkenreihen 11 und 12 kleiner, an einer Übergangsstelle, nämlich der in Fig. 2 angedeuteten Berührstelle der Platte 2 mit den Zinken 13, gleich und benachbart dazu - näher zur Längsmittelebene L des Halters 3 - größer als die Plattendicke. Es ist allerdings nicht zwingend, daß eine Platte 2 mit ihren Längsrändern gleichzeitig die Zinken 13 beider Reihen 11 und 12 berührt, wie es in Fig. 2 für die größtmögliche Platte 2 angedeutet ist, sondern eine kleinere Platte wird jeweils nur die unten liegenden Zinken 13 eines Halters 3 berühren.

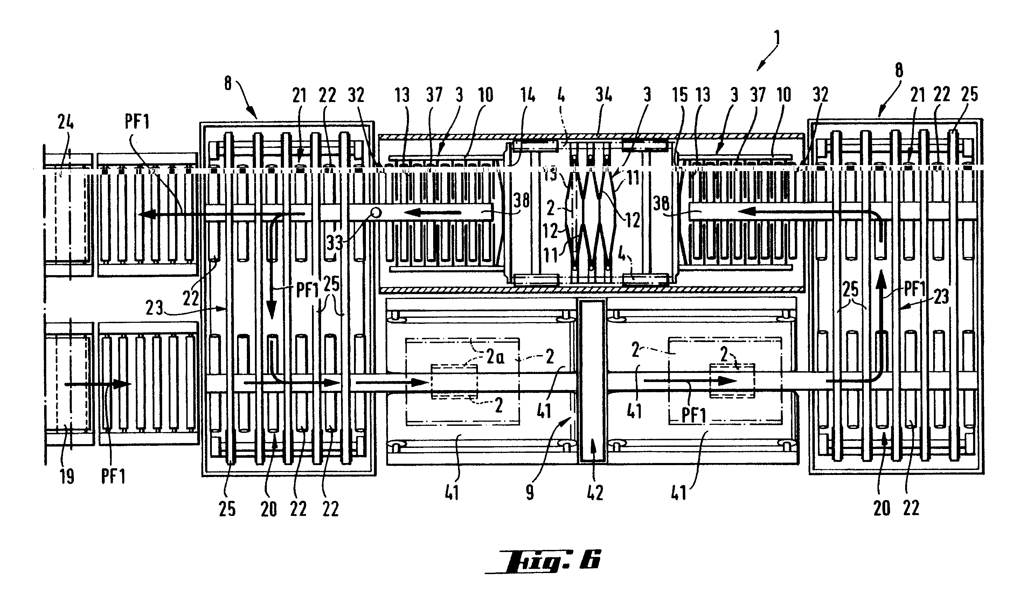

Die Zinken 13 einer Reihe 11 und 12 sind jeweils parallel zueinander und rechtwinklig zu dem Holm 10 angeordnet und jeweils zwei unter einem spitzen Winkel etwa von derselben Stelle des Holmes 10 ausgehende Zinken 13 liegen dabei in einer rechtwinklig zu der Erstreckung der Holme 10 und auch rechtwinklig zu der Längsmittelebene L angeordneten Ebene, was vor allem anhand der Fig. 3 und 4 deutlich wird. Die beiden Holme 10 mit ihren V-förmig angeordneten, gegeneinander gerichteten Reihen 11 und 12 von Zinken 13 sind spiegelsymmetrisch zu der zwischen den Holmen 10 verlaufenden Längsmittelebene L angeordnet, so daß die Unterstützung einer Platte 2 an dem Halter unabhängig von dessen Orientierung immer gleich ist. Demgemäß können die noch zu beschreibenden Fördermittel zum Übergeben der Platten an den Übergabestationen 8 ebenfalls jeweils übereinstimmen.

In Fig. 2 erkennt man ferner, daß die Winkelhalbierenden W der von den im Ausführungsbeispiel geraden Zinken 13 des einen Holmes 10 jeweils gebildeten spitzen Winkel mit denen der von den Zinken 13 des anderen Holmes 10 gebildeten Winkeln übereinstimmen. Beide Winkelhalbierenden W setzen sich zu einer geraden Linie fort, so daß alle Winkelhalbierenden W der von den Zinken 13 der Holme 10 jeweils gebildeten spitzen Winkel mit den Holmen 10 in einer gemeinsamen Ebene liegen, die von der Längsmittelebene L geschnitten wird und zu der diese Längsmittelebene L rechtwinklig angeordnet ist.

Der Abstand zwischen jeweils einander in Reihe benachbarter Zinken 13 ist größer als die seitliche Ausdehnung dieser Zinken und beträgt z.B. das Fünffache bis Zehnfache, insbesondere das Siebenfache oder Achtfache des Zinkendurchmessers oder der Zinkenbreite. Wie erwähnt, sind im Ausführungsbeispiel die Zinken 13 gerade, jedoch könnten sie u.U. auch bogenförmig sein, wobei ihre Krümmung zweckmäßigerweise in derjenigen Ebene liegt, deren Draufsicht in Fig. 2 dargestellt ist.

Zwischen den freien Enden der einander vorzugsweise genau in einer gemeinsamen Ebene gegenüberliegenden Zinken 13 eines Halters 3 ist ein Zwischenraum 16 (vgl. Fig. 1) vorgesehen, der kleiner ist, als es der geringsten Breite einer zu haltenden Platte oder Leiterplatte 2 entspricht. Die Abmessung dieses Zwischenraumes 16 beträgt vorzugsweise etwa ein Sechstel bis ein Viertel, insbesondere ein Fünftel des Abstandes der beiden parallelen Holme 10. In noch zu beschreibender Weise kann durch diesen Zwischenraum 16 ein Träger für seitlich von dem Träger abstehende Zinken oder Rollen bewegt werden, um die auf den Zinken 13 des Halters 3 liegende Platte 2 anzuheben und aus dem Halter zu entnehmen oder nach dem Einführen in den Halter in diesem abzulegen. Dabei kann in nicht näher dargestellter Weise der Abstand der Holme 10 zueinander und damit auch der Zwischenraum 16 verstellbar sein. Dadurch läßt sich eine Anpassung an in ihren Abmessungen noch weiter von einander abweichende Platten 2 durchführen, als sie in Fig. 1 angedeutet sind.

Gemäß Fig. 1 schließen die Schenkel 15a und 15b des stirnseitigen Anschlages 15 einen stumpfen Winkel miteinander ein, wobei jedoch zwischen den beiden Stellen 15c, an denen die Schenkel 15a und 15b jeweils unter spitzen Winkeln von dem Träger 14 abgehen, vorzugsweise eine geradlinige Verbindung 15d der beiden Schenkel 15a und 15b etwa von der Länge vorgesehen ist, die dem Abstand bzw. der Abmessung des Zwischenraumes 16 zwischen den freien Enden der Zinken 13 etwa entspricht oder diese gemäß Fig. 2 geringfügig übertrifft und die kleiner als die Breite der kleinsten zu haltenden Platte ist. Somit wird durch die schräg gegenüber dem Träger 14 angeordneten Schenkel 15a und 15b möglichst wenig von der Gesamtlänge des Halters 3 verbraucht.

Es sei an dieser Stelle erwähnt, daß der Träger 14 ggf. selbst so geformt sein könnte, daß er den Schenkeln 15a und 15b entsprechende Anschlagbereiche für die Platten 2 aufweist, also den Anschlag 15 selber bildet.

In den Fig. 2 bis 4 ist gezeigt, daß der stirnseitige Anschlag 15 im Bereich des Trägers 14 und somit auch des Zwischenraumes 16 quer zu der zwischen dem Träger 14 und den Holmen 10 aufgespannten Ebene, in welcher übrigens die Winkelhalbierenden W liegen, eine größere Breite b als der Träger 14 und die Holme 10 hat und seine Breite etwa dem lichten Abstand a der jeweils V-förmig auseinander laufenden Zinken 13 zweier Zinkenreihen 11 und 12 eines Holmes 10 an ihren freien Enden entspricht. In Fig. 2 erkennt man, daß die Breite b den Abstand a sogar noch um die Querschnittsabmessungen der Zinken 13 übertrifft, so daß sich ein insgesamt geschlossener Umriß ergibt.

Diese Breite b des stirnseitigen Anschlages 15 und dabei gemäß Fig. 2 die Breite der unter stumpfem Winkel zueinander stehenden Schenkel 15a und 15b nimmt gemäß Fig. 2 gegen die Holme 10 hin stetig ab und zwar mit der Form bzw. unter dem Winkel, unter welchem jeweils die V-förmig zueinander angeordneten Zinken 13 zueinander stehen, so daß der stirnseitige Anschlag 15 die Projektion der Reihen 11 und 12 der Zinken 13 stirnseitig vor dem Träger 14 oder an diesem abschließt und die Ränder der Schenkel 15a und 15b des stirnseitigen Anschlages 15 jeweils etwa in der von den Zinken 13 einer Reihe 11 oder 12 gebildeten Ebene verlaufen. Trotz der Vielzahl von Einzelteilen erhält so der Halter 3 insgesamt eine weitgehend stetige Umfangsfläche.

Gemäß Fig. 1 und 2 überragt der Träger 14 die Befestigungsstellen der beiden von ihm abgehenden parallelen Holme 10 beidseits und hat in dem Bereich dieser Überstände 17 Befestigungs- oder Kupplungsstellen, im Ausführungsbeispiel Lochungen 18, zum Verbinden mit Vorschubmitteln, im vorliegenden Falle der umlaufenden Kette 4, für den Transport der Halter 3 und der Platten 2.

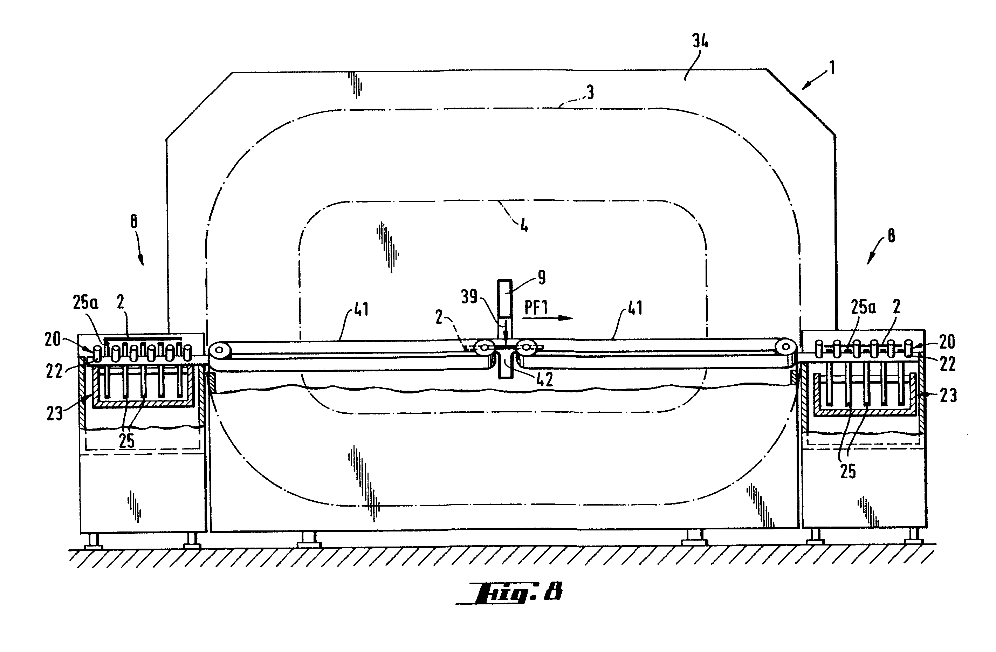

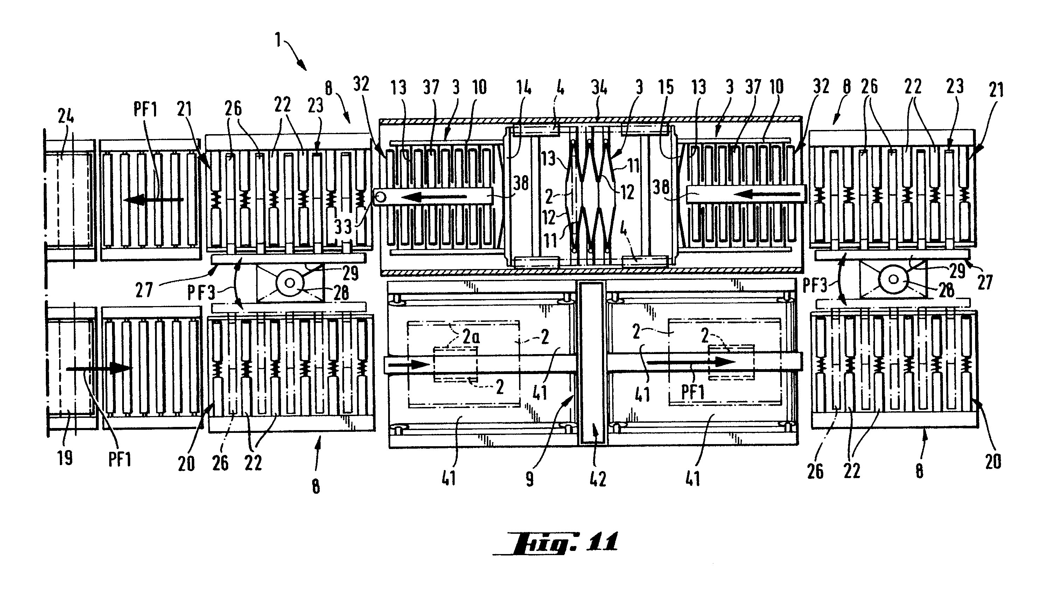

Wie bereits erwähnt und vor allem in Fig. 7, aber auch in Fig. 6 und 11 deutlich erkennbar, ist als Vorschubmittel für eine Vielzahl von in gleichbleibendem Abstand zueinander daran angeordnete Halter 3 ein endlos umlaufendes Zugelement, welches also in Zugrichtung Kräfte über tragen kann, dies aber quer dazu oder in Druckrichtung nicht oder kaum vermag, im Ausführungsbeispiel die schon erwähnte Kette 4 vorgesehen. Auch entsprechend stabile Bänder, Seile od. dgl. sind möglich. Dabei wird vor allem in Fig. 7 deutlich, daß die Holme 10 der Halter 3 etwa rechtwinklig zur Längserstreckung und Bewegungsrichtung der Kette 4 nach außen abstehen, wobei die freien, dem Träger 14 abgewandten Enden der Holme 10 von der Kette 4 weggerichtet sind. Somit können die Halter 3 und ihre Holme 10 an den Umlenkstellen aus ihrer sonst parallel zueinander orientierten Lage problemlos in eine Winkelstellung relativ zueinander übergehen, also die Umlenkung mitmachen und außerdem werden so die Halter 3 besonders gut zum Be- und Entladen mit den Platten 2 zugänglich.

In Fig. 5 ist eine Gesamt-Seitenansicht der Vorrichtung 1 schematisch dargestellt. Ein Beladegerät 19 kann dabei die Platten 2 zu einer ersten Rollenbahn 20 bringen, von wo sie der eigentlichen Bearbeitung zugeführt werden können.

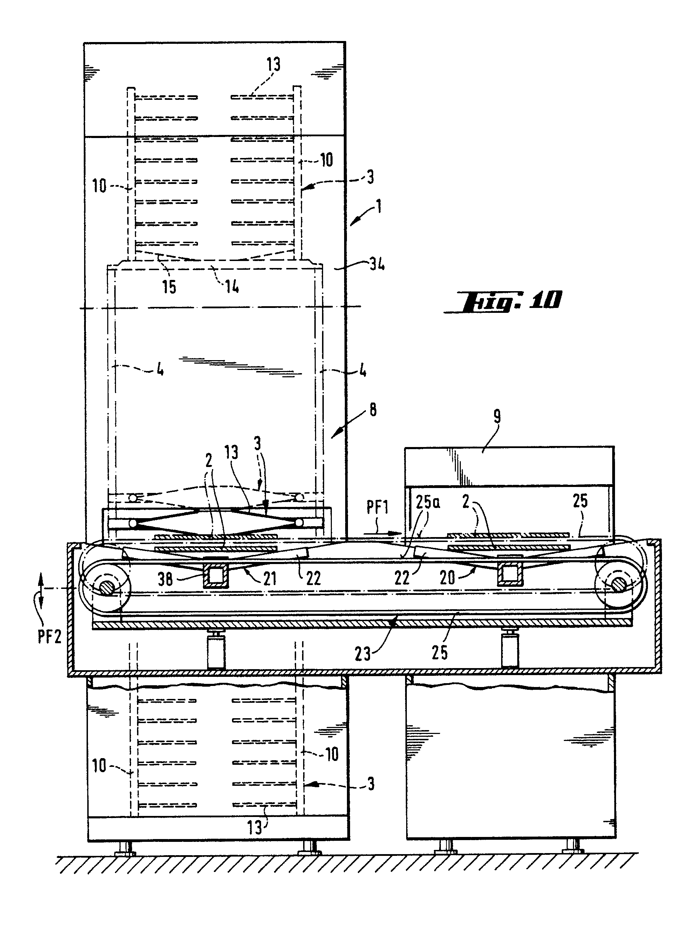

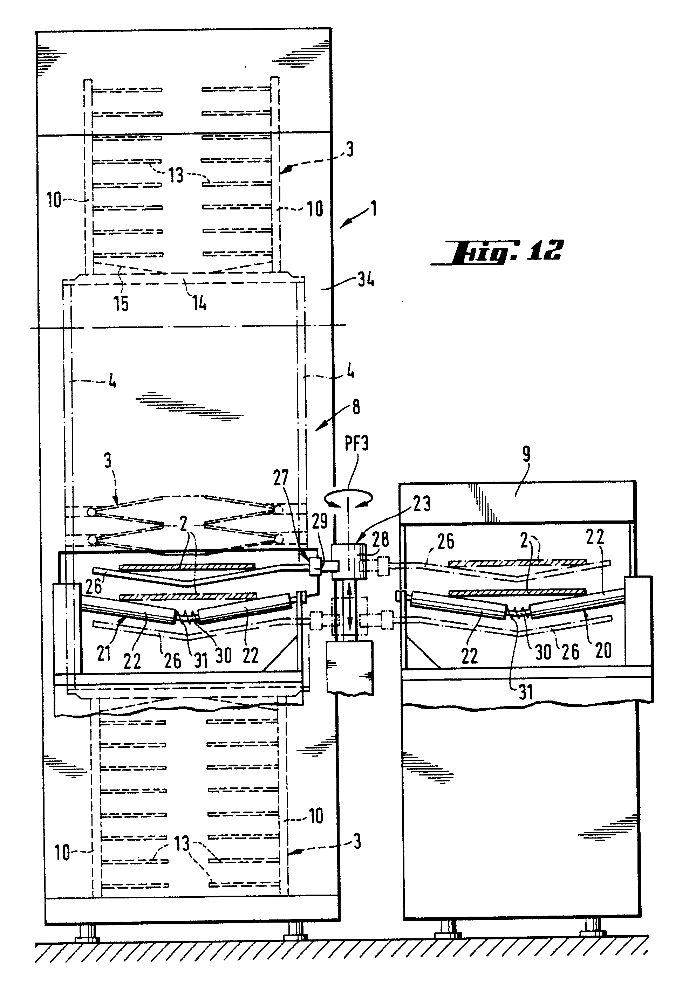

In den Fig. 6, 9, 10, 11 und 12 erkennt man bei der Vorrichtung 1, daß seitlich bzw. in horizontaler Richtung quer zur Vorschubrichtung des endlos umlaufenden Vorschubmittels, also der Kette 4, mit den daran befestigten oder angekuppelten Haltern 3 neben dieser Kette 4 mit den Haltern 3 die Beschichtungs- oder Belackungsstation 9 angeordnet ist und daß jeweils in einem eine vertikale Vorschubrichtung aufweisenden Förderbereich der umlaufenden Kette 4 die Übergabestationen 8, im Ausführungsbeispiel Rollenbahnen 21 mit jeweils V-förmig zueinander angeordneten Paaren von antreibbaren Rollen 22 zum Entnehmen der Platten 2 aus den Haltern 3 und außerhalb des von den Haltern 3 durchlaufenen Bereiches im Ganzen mit 23 bezeichnete Querförderer vorgesehen sind. Mit diesen können die Platten 2 seitlich versetzt und somit der Beschichtungs- oder Belackungsstation 9 zugeführt werden, wie es durch Pfeile in Fig. 6 von oben sowie auch in Fig. 10, aber außerdem auch in Fig. 11 und 12 angedeutet ist. In Fig. 6 und 11 erkennt man ferner, daß nach dem Beschichten oder Lackieren in umgekehrter Weise die Platten 2 der zweiten Übergabestation 8 und dann wieder einem Halter 3 an der Kette 4 zuführbar sind. In den Fig. 6 und 10 einerseits und den Fig. 11 und 12 andererseits sind dabei zwei unterschiedliche Konstruktionen von Querförderern 23 dargestellt. Diese Querförderer 23 bringen die aus Haltern 3 entnommenen Platten 2 von der Rollenbahn 21 zu der sich auch an das Beladegerät 19 anschließenden Rollenbahn 20, falls eine Platte 2 in noch zu beschreibender Weise eine zweite Beschichtung erhalten soll. In Förderrichtung hinter der Belackungsstation 9 befördern die Querförderer 23 die Platten 2 zu den Haltern 3 an der Kette 4, womit sie wiederum zu der Rollenbahn 21 und eventuell auch zu einem Entladegerät 24 gelangen können, was im folgenden näher erläutert wird.

Beim Ausführungsbeispiel nach den Fig. 6 und 10 sind als Querförderer 23 querfördernde, zwischen die Rollen 22 der Rollenbahnen 20 und 21 passende und in den Zwischenräumen unter das Rollenniveau absenkbare und über das Rollenniveau anhebbare (vgl. Fig. 10) Hubbänder 25 vorgesehen, deren oberes Fördertrum 25a bis zwischen die Rollen des vor bzw. hinter der Belackungsstation 9 angeordneten Rollenförderers 20 reicht. Vor allem aus Fig. 6 wird deutlich, daß die Länge der Hubbänder 25 und ihrer Fördertrums 25a so ausgelegt ist, daß eine Platte 2 nach dem Verlassen eines Halters 3 aus dessen Flucht quer in die Förderstrecke der Belackungsstation 9 und nach deren Durchlaufen wieder quer zurück in Flucht mit einem Halter 3 gebracht werden kann. Diese Querförderung ist in Fig. 6 und 10 durch die Pfeile Pf 1 angedeutet. Ferner ist in Fig. 10 durch den Doppelpfeil Pf 2 die Höhenverstellbarkeit der Hubbänder 25 verdeutlicht, wobei sich das in Fig. 10 schematisch angedeutete Hubband 25 in Obenstellung befindet, während seine unter die Rollenbahnen 20 und 21 abgesenkte Position strichpunktiert dargestellt ist.

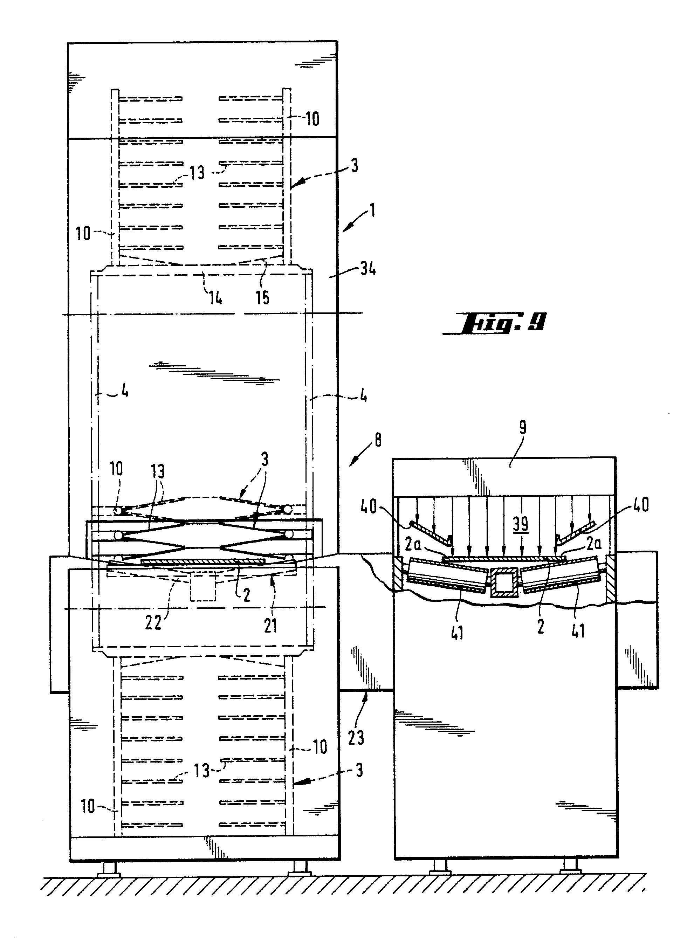

Diese Hubbänder sind ferner in den Fig. 7 und 8 teils in Obenstellung - vom Betrachter aus gesehen die links vor dem Eintritt in die Belackungsstation befindlichen Hubbänder -, teils in abgesenkter Position - die vom Betrachter aus gesehen rechts in Vorschubrichtung hinter der Belackungsstation 9 befindlichen Hubbänder 25 - schematisiert dargestellt, wobei ganz deutlich wird, wie diese Hubbänder 25 in den Zwischenräumen zwischen den Rollen 22 angehoben und abgesenkt werden können und dadurch die Platten 2 von den Rollen 22 aufnehmen oder auf diesen ablegen.

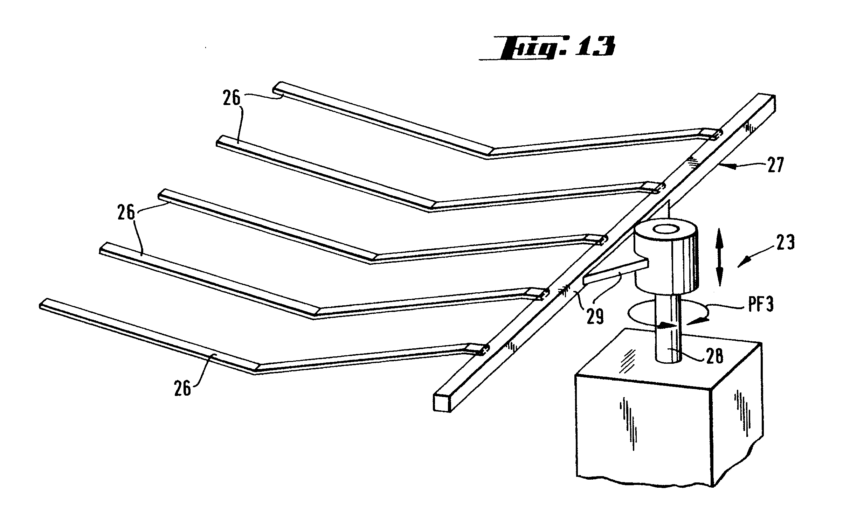

Eine abgewandelte Konstruktion der Querförderer 23 ist in den Fig. 11 bis 13 dargestellt. In diesem Falle sind als Querförderer 23 mit ihren Zinken 26 zwischen die einzelnen Rollen 22 der Rollenbahnen 20 und 21 an der Übergabestation 8 und der Belackungsstation 9 passende Hub- und Schwenkrechen 27 vorgesehen, die an einer zwischen diesen beiden Rollenbahnen 20 und 21 angeordneten Hubsäule 28 angeordnet, unter das Niveau der Rollen 22 absenkbar und über deren Niveau anhebbar und in angehobener Position gemäß dem gekrümmten Doppelpfeil Pf 3 in den Fig. 11 bis 13 um wenigstens 180° um eine vertikale Achse, die Achse der Hubsäule 28, verdrehbar sind. Dabei verdeutlicht vor allem Fig. 13, daß die Zinken 26 etwa in ihrer Mitte unter einem stumpfen Winkel gebogen sind, also ein stumpfes V bilden, welches dem "V" entspricht, das die Rollen 22 eines jeden Rollenpaares der Rollenbahnen 20 und 21 miteinander bilden und das auch der Anordnung der Zinken 13 der Halter 3 entspricht. Gegebenenfalls könnten die Zinken 26 aber auch konkav gekrümmt sein. Somit kann auch darauf eine Platte 2 in der in Fig. 12 angedeuteten Weise zu liegen kommen und dabei die Zinken 26 nur mit dem lackfreien Randbereich 2a berühren.

In Fig. 13 ist ein einfacher derartiger Hub- und Schwenkrechen 27 dargestellt. Dieser könnte aber auch ein Doppelrechen sein, bei welchem von einem an der Hubund Schwenksäule angeordneten Tragprofil 29 nach den beiden einander gegenüberliegenden Seiten in symmetrischer Anordnung Zinken 26 abstehen, die jeweils in die Zwischenräume der Rollen 22 der Rollenbahnen 20 und 21 reichen und passen. Ein solcher Doppelrechen brauchte dann für jedes Umsetzen von Platten nur in einer Richtung um 180° verdreht zu werden, um sogleich wieder in Gebrauchsstellung zu sein.

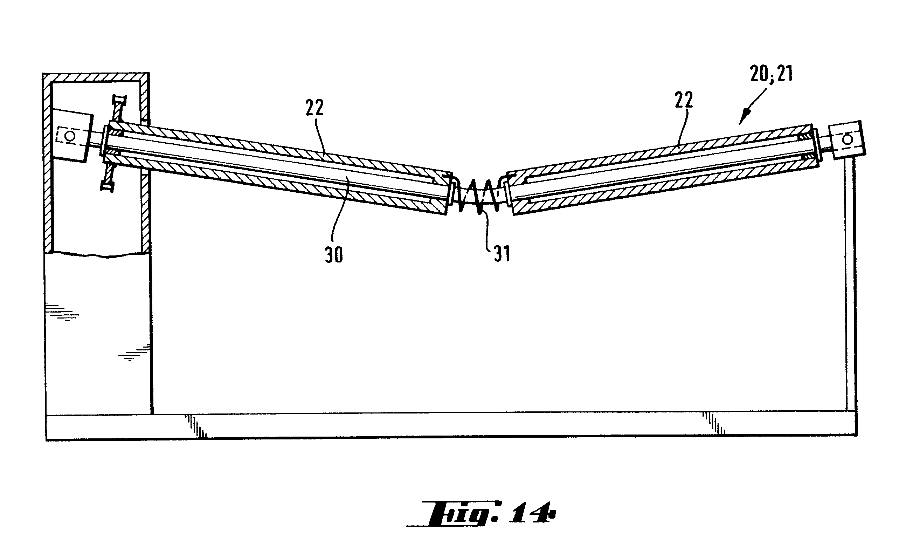

Es wurde schon erwähnt, daß die Rollen 22 jeweils unter einem stumpfen Winkel V-förmig zueinander stehen. In Fig. 14 ist angedeutet, daß diese innerhalb der Rollenbahnen 20 und 21 jeweils V-förmig zueinander geneigten Rollen 22 auf einer entsprechend V-förmig gebogenen oder gekrümmten Achse 30 gelagertsind, wobei eine der beiden Rollen angetrieben und die andere mit der angetriebenen Rolle über ein elastisches Verbindungselement, in Fig. 14 eine Wendelfeder 31 in Drehrichtung gekuppelt ist, so daß beide Rollen 22 trotz ihrer V-förmigen Anordnung nur einen Antrieb benötigen und synchron in Drehung versetzt werden können. Denkbar wäre aber auch, die Rollen 22 auf einer elastischen Welle, die ihrerseits angetrieben ist, zu lagern oder für die jeweils zueinander geneigten Rollen jeweils eigene, synchrone Antriebe vorzusehen.

Vor allem aus Fig. 12 wird deutlich, daß der Neigungswinkel der V-förmig angeordneten Transportrollen 22 sowie der Zinken 26 von ihrer Knick- oder Biegestelle aus und die Neigungswinkel der von den beiden Holmen 10 insbesondere geradlinig aufeinander zulaufenden Zinken 13 der Halter 3 miteinander etwa übereinstimmen.

Das als Kette 4 ausgebildete Vorschubelement ist in Richtung der in Fig. 7 erkennbaren Pfeile Pf 4, Pf 5, Pf 6 und Pf 7 taktförmig bewegbar. Dabei wird in Fig. 7 auch deutlich, daß jeweils ein Halter 3 in der Übergabestation 8 zu der Belackungsstation 9 und ein Halter 3 in der gegenüberliegenden Übergabestation 8 von der Belackungsstation 9 wieder zurück im Bereich und in der Höhe der ab- und zuführenden Rollenbahn 21 angeordnet ist, wobei die noch zu beschreibenden Eingabe- und Ausgabemittel 32 ortsfest und bezüglich ihres Niveaus unveränderlich im Umriß dieser Halter 3 bzw. in diese Halter 3 eingreifend angeordnet sind.

In den Fig. 6 und 11 ist dargestellt, daß an der Übergabestation 8 zu der Belackungsstation 9 in Flucht mit der Rollenbahn 21 das Entladegerät 24 für beschichtete Platten 2 und außerdem eine Sensoreinrichtung 33, insbesondere eine optische Sensoreinrichtung 33 angeordnet sind. Die Sensoreinrichtung 33 steuert das Entladegerät 24 und die zu diesem führende Rollenbahn 21 an, wenn eine Platte 2 beidseitig beschichtet ist; sie steuert den Querförderer 23 zu der Belackungsstation 9 hin an, wenn die Platte 2 nur einseitig beschichtet ist, aber auf ihren beiden Flächen beschichtet werden soll.

Die Kette 4 mit den Haltern 3 ist innerhalb eines Gehäuses 34 angeordnet. Der aufwärts, im Ausführungsbeispiel vertikal aufwärtsführende Bereich gemäß dem Pfeil Pf 4 des Vorschubelementes, der sich in Förderrichtung hinter der Belakkungsstation befindet, weist innerhalb dieses Gehäuses 34 Zuluft- und Absaugeinrichtungen, nämlich Zuluftkanäle 35 und Abluft-Absaugungen 36 zum Belüften und Vortrocknen der beschichteten Platten 2 auf. Dabei erkennt man in Fig. 7, daß die Zuluftkanäle 35 an der Außenseite der auf sie gerichteten Halter 3 und die Abluft-Absaugung 36 am entgegengesetzten Ende der Halter im von der Kette 4 umschlossenen Innenraum angeordnet sind, so daß die Belüftungs- und Trocknungsluft in diesem Förderbereich etwa parallel zu den Oberflächen der Platten 2 geführt wird.

Ein Teil des Förderweges der Kette 4 ist als Trocknungsstation 6 ausgebildet und zwar im Ausführungsbeispiel gemäß Fig. 7 der sich an den aufwärts gerichteten Teil des Förderweges anschließende, insbesondere horizontal entsprechend dem Pfeil Pf 5 in Fig. 7 entgegengesetzt zur Förderrichtung in der Belackungsstation 9 bewegbare Teil der Kette 4. In diesem Bereich sind die Halter 3 und damit auch die Platten 2 etwa vertikal nach oben weisend orientiert und die Platten 2 stützen sich innerhalb der Halter 3 an den Anschlägen 15 und deren Schenkeln 15a und 15b ab.

Der in Förderrichtung gemäß dem Pfeil Pf 6 im Anschluß an die Trocknungsstation 6 angeordnete, wieder abwärts und zwar vertikal abwärts zu der Übergabestation 8 führende Teil der Kette 4 bzw. des Weges der Kette 4 innerhalb des Gehäuses 34 ist als Kühl- und Nachtrocknungsstrecke oder -station 7 ausgebildet, an deren Ende die Entnahme- oder Ausgabemittel 32 und der Sensor 33 angeordnet sind. Unterhalb der Ausgabemittel 32 sind die Halter 3 an der Kette 4 zwischen der abwärts gerichteten Förderstrecke und der aufwärts gerichteten Förderstrecke in dem dort befindlichen, parallel zu dem Förderweg in der Belakkungsstation 9 bewegbaren Untertrum leer. Auf Grund dieser Gesamtanordnung können die Halter 3 in ihrer Konstruktion relativ einfach sein, weil die Platten 2 nur dann in diesen Haltern liegen, wenn die Halter auch eine horizontale oder aufwärtsgerichtete Position haben, so daß keinerlei kraftschlüssige Klammern oder dgl. zum Fixieren der Platten 2 innerhalb der Halter 3 erforderlich sind.

Als Ein- und Ausgabemittel 32 erkennt man vor allem in den Fig. 6 und 11, andeutungsweise aber auch in Fig. 7, jeweils eine in horizontaler Richtung fördernde, zwischen die Reihen der Zinken 13 des an einer Übergabestation 8 befindlichen Halters 3 eingreifende Eingreif-Rollenbahn mit vorzugsweise in stumpfem Winkel zueinander stehenden, angetriebenen Rollen 37, die stationär vorgesehen ist, wobei diese Rollen 37 jeweils unterhalb bzw. oberhalb der seitlichen Abstände zwischen einzelnen benachbarten Zinken 13 des Halters 3 angeordnet sind und ein mittlerer Rollenträger 38, von welchem die Achsen der Rollen 37 und somit auch die Rollen 37 selbst beidseits abstehen, unterhalb bzw. oberhalb des zwischen den freien Enden der Zinken 13 vorhandenen Zwischenraumes 16 der Halter 3 angeordnet sind. Dadurch ist es möglich, die Halter 3 in vertikaler Richtung kammartig gemäß dem Pfeil Pf 6 von oben nach unten oder gemäß dem Pfeil Pf 4 von unten nach oben durch die Eingreif-Rollenbahn zu bewegen und bei der Abwärtsbewegung eine zwischen den Zinken 13 befindliche Platte 2 auf der Eingreif-Rollenbahn abzulegen bzw. bei ihrem Durchgang von unten nach oben eine von der Übergabestation 8 kommende, auf der Eingreif-Rollenbahn liegende Platte in Richtung des Pfeiles Pf 4 mitzunehmen. Diese als Eingreif-Rollenbahn ausgebildeten Ein- und Ausgabemittel 32 stellen somit die endgültige Verbindung zwischen der umlaufenden Kette 4 mit den Haltern 3 einerseits und den Übergabestationen 8 und der Belackungsstation 9 her und schließen den gesamten Förderweg der Platten 2.

In Fig. 9 ist angedeutet, daß der Lack-Gießvorhang 39 oder der Lack-Sprühbereich der Belackungsstation 9 schmaler als der jeweils zu beschichtende Bereich der Platte 2 ist, damit der lackfreie Rand 2a entsteht. Die Platte 2 ist deshalb an diesen in Förderrichtung beidseitigen Rändern 2a gegenüber der Lackzuführung beispielsweise durch Ableitbleche 40 abgeschirmt. Dadurch wird sichergestellt und erreicht, daß die zum Auflegen auf die V-förmig angeordneten Rollen und die entsprechend angeordneten Zinken dienenden lackfreien Ränder 2a entstehen.

In den Fig. 5, 6, 8, und 11 ist die Belackungsstation 9 schematisch dargestellt. Vor allem erkennt man, daß sie zwei im Bereich eines Gießvorhanges oder einer Gießsprüheinrichtung unterbrochene, sich in Förderrichtung fortsetzende Förderbänder 41 zum Transport der Platte 2 durch die Belackungsstation 9 hindurch aufweist. An der Unterbrechung 42 kann der überschüssige Lack ablaufen. Gegebenenfalls könnten auch Rollenförderer Verwendung finden.

Die beiden Förderbänder 41. der Belackungsstation 9 sind in Längsrichtung unterteilt und ihre parallelen Hälften sind gemäß den Fig. 10 und 12 V-förmig unter stumpfem Winkel zueinander angeordnet. Dabei kann der V-Winkel der parallelen Hälfte der Förderbänder 41 der Belackungsstation 9 dem der Zuführ-Rollenbahn und der Zinken 26 des Schwenkrechens 27 und vorzugsweise dem Winkel zwischen den jeweils gegeneinander gerichteten Zinken 13 des Halters 3 entsprechen, so daß auch hier die Platte 2 dieselben Unterstützungs- und Auflageverhältnisse vorfindet.

Zusammenfassend funktioniert die vorbeschriebene Anlage und Vorrichtung wie folgt:

Insgesamt handelt es sich bei der Transportvorrichtung 1 um eine Umlaufbeschichtungsanlage, die in erster Linie für das beidseitige Beschichten von Leiterplatten vorgesehen ist, welche nach einer ersten Beschichtung um 180° gewendet und außerdem belüftet, getrocknet und gekühlt werden. Um zu entscheiden und zu erkennen, ob eine Leiterplatte 2 ein- oder beidseitig beschichtet ist und somit erneut der Belackungsstation 9 zugeführt oder über das Entladegerät 24 ausgeschleust werden soll, ist ausgangs der Kühlstation 7 die Sensoreinrichtung 33 angeordnet.

Der Transport der Platten 2 durch die gesamte Vorrichtung 1 erfolgt getaktet. Um die Leiterplattenbeschichtung nach ihrer Aufbringung so gut wie möglich zu schonen, sollen die Platten 2 nur an ihren äußeren Längsrändern 2a mit den verschiedenen Transportmitteln, vor allem den Rollen 22 der Rollenbahnen 20 und 21 sowie der Förderbänder 41 und auch der Zinken 13 und 26 in Berührung stehen, weshalb all diese Mittel jeweils V-förmig unter stumpfem Winkel zueinander angeordnet sind. Lediglich die an das Beladegerät 19 unmittelbar anschließenden oder die unmittelbar vor dem Entladegerät 24 befindlichen Rollen oder Bänder können im wesentlichen horizontal angeordnet sein.

Auf Grund der vorbeschriebenen Anordnung der Halter 3 an der Kette 4, die in der Vortrocknungsstation 5, Trocknungsstation 6 und Kühlstation 7 umläuft, kann jeder Halter 3 eingangsseitig in eine Position getaktet werden, in der seine oberen Zinken 13 sich oberhalb und die unteren Zinken 13 sich unterhalb der V-förmig angeordneten Rollen 37 der Eingabemittel 32 befinden. Die Leiterplatte 2 kann nun eingefahren und beim nächsten Takt von dem Eingabemittel 32 hochgehoben werden, wobei der nächste Halter 3 in die Eingabeposition gelangt. Dabei handelt es sich um die Übergabestation 8 zwischen der Belackungsstation 9 und der Vortrocknungsstation 5.

Zur Entnahme der Leiterplatten 2 werden die Halter 3 ausgangsseitig jeweils in eine Position getaktet, (Fig. 7 links angeordnete Übergabestation 8) in der die Leiterplatten 2 auf den V-Rollen 37 der Ausgabemittel 32 aufliegen. Die oberen V-Schenkel des Halters 3 die Leiterplattenoberfläche jedoch noch nicht öerühren. Dabei sind die nun unten liegenden Zinken 13 an der vorhergehenden Übergabestation 8 die obenliegenden Zinken gewesen. Nun werden die Rollen 37 angetrieben und dadurch wird die Leiterplatte 2 aus dem Halter 3 ausgefahren. Danach werden die Halter 3 einen weiteren Schritt weitergetaktet, so daß die nächste Leiterplatte entnommen und an der gegenüberliegenden Seite die nächste Leiterplatte zugeführt werden können. Die Eingabe und die Entnahme der Leiterplatten 3 erfolgt also in demselben Arbeitstakt.

Jeweils beim Passieren der Sensoreinrichtung 33 an der am Ende der Kühlstation 7 angeordneten Übergabestation 8 wird entschieden, ob die Leiterplatte 2 erneut der Belackungsstation 9 mit Hilfe der Querförderer 23 zugeführt oder ausgeschleust wird.

Insgesamt ergibt sich somit eine Transportvorrichtung 1 mit Belackungsstation 9, in der Platten 2 schonend gehandhabt werden können, wobei vor allem auf Grund der Ausbildung des Halters 3 dieser die Leiterplatten nach einem ersten Beschichtungsvorgang aufnehmen, während einer Belüftung, Trocknung und Kühlung transportieren, haltern und wenden kann und aus welchem die Platte problemlos und ohne Gefahr für die Oberflächenbeschichtung wieder entnommen und erforderlichenfalls erneut der Belackungsstation 9 zugeführt werden kann. Da die Platten 2 auf Grund der speziellen Konstruktion der Halter 3 lose in diesen liegen können und dabei nur kanten und somit vor allem bei im Querschnitt runden Zinken Punktberührung erfahren, brauchen keine aufwendigen Klemmen, Klammern od. dgl. betätigt oder beim Wechsel der einzelnen Arbeitsstationen umgesetzt zu werden. Da die Halter 3 an der Kette 4 umlaufen, machen sie automatisch eine Wendebewegung, so daß für die beidseitige Beschichtung nicht zwei Belackungsstationen und dazwischen liegende Trocknungseinrichtungen erforderlich sind, sondern in ein und derselben Belackungsstation und mit Hilfe nur einer Trocknungseinrichtung beide Beschichtungen durchgeführt werden können. Insgesamt wird somit nicht zuletzt durch die zweckmäßige Konstruktion der Halter 3 die gesamte Transportvorrichtung 1 platzsparend und in ihrem maschinellen Aufwand rentabel.

Die Transportvorrichtung 1 für Platten 2 oder plattenförmige Werkstücke, insbesondere mit empfindlicher Ober fläche, vorzugsweise für Leiterplatten, die mit Kunststoff, z.B. UV-härtbarem Kunststoff, mit Lack od. dgl. beschichtet und dann getrocknet werden, ist als Umlaufbeschichtungsanlage ausgebildet. Dabei enthält die Vorrichtung 1 vor allem Halter 3 zum Erfassen der Platten 2 an den Plattenrändern 2a bei deren Handhabung und zweckmäßigerweise als Ketten 4 ausgebildete Vorschubmittel zum Transport dieser Halter 3. Der Halter 3 hat zwei parallele Holme 10, an denen jeweils zwei Reihen 11, 12 von rechenförmig angeordneten Zinken 13 vorgesehen sind, wobei die Zinken 13 der einen Reihe 11 eines Holmes 10 mit denen der zweite Reihe 12 dieses Holmes 10 einen spitzen Winkel einschließen und also die beiden Reihen 11 und 12 im Querschnitt gesehen V-förmig zueinander angeordnet sind. Die freien Enden der Zinken 13 des einen Holmes 10 sind dabei gegen die freien Enden der Zinken 13 des anderen Holmes 10 gerichtet. Die beiden Holme 10 gehen von einem gemeinsamen, sie haltenden und verbindenden Träger 14 aus, an welchem auf der Seite, an der die Holme 10 abgehen, ein stirnseitiger Anschlag 15 für die Platten 2 vorgesehen ist, der zwei unter einem stumpfen Winkel zueinander stehende, zu den Holmen 10 verlaufende Schenkel 15a, 15b hat, so daß eine sich abstützende RechteckPlatte nur mit ihren diesem Anschlag 15 zugewandten Ecken anstößt.

## Ansprüche

1. Transportvorrichtung (1) für Platten (2) oder plattenförmige Werkstücke, insbesondere mit emfindlicher Oberfläche, vorzugsweise für Leiterplatten, die mit Kunststoff, zum Beispiel UV-härtbarem Kunststoff, mit Lack oder dergleichen beschichtet und dann getrocknet werden, wobei die Vorrichtung Halter (3) zum Erfassen der Platten (2) an den Plattenrändern (2a) bei ihrer Handhabung und Vorschubmittel zu ihrem Transport zu und durch Bearbeitungsstationen aufweist, **dadurch gekennzeichnet,** daß jeder Halter (3) wenigstens zwei parallele Holme (10) hat, an denen jeweils zwei Reihen (11, 12) von rechenförmig angeordneten Zinken (13) vorgesehen sind, wobei die Zinken (13) der einen Reihe (11) eines Holmes (10) mit denen der zweiten Reihe (12) dieses Holmes (10) einen spitzen Winkel einschließen und also die beiden Reihen (11, 12) im Querschnitt gesehen V-förmig zueinander angeordnet sind und wobei die freien Enden der Zinken (13) des einen Holmes (10) etwa gegen die freien Enden der Zinken (13) des anderen Holmes (10) gerichtet sind, daß der zu der Längsmittelebene zwischen den beiden parallelen Holmen (10) zunehmende lichte Abstand zwischen den Zinkenreihen (11, 12) wenigstens über einen Teil des zwischen den Holmen (10) befindlichen Bereiches größer als die Dicke einer zu haltenden Platte (2) ist, daß die beiden Holme (10) an einem ihrer Enden einen sie haltenden und verbindenden Träger (14) aufweisen und daß an diesem Träger

(14) ein stirnseitiger Anschlag (15) für Platten (2) vorgesehen ist, der etwa von der Mitte des Trägers (14) ausgehend zwei unter einem stumpfen Winkel zueinander stehende, zu den Holmen (10) verlaufende Schenkel (15a, 15b) hat.

2. Vorrichtung nach Anspruch 1, dadurch gekennzeichnet, daß der lichte Abstand zwischen den V-förmig zueinander angeordneten Zinkenreihen (11, 12) unmittelbar an oder neben dem jeweiligen Holm (10) kleiner, an einer Übergangsstelle gleich und benachbart dazu - näher zur Längsmittelebene (L) des Halters (3) größer als die Plattendicke ist.

3. Vorrichtung nach Anspruch 1 oder 2, dadurch gekennzeichnet, daß die Zinken (13) einer Reihe (11, 12) jeweils parallel zueinander und rechtwinklig zu dem Holm (10) angeordnet sind und daß jeweils zwei unter einem spitzen Winkel etwa von derselben Stelle des Holmes (10) ausgehende Zinken (13) in einer rechtwinklig zu der Erstreckung der Holme (10) angeordneten Ebene liegen.

4. Vorrichtung nach einem der Ansprüche 1 bis 3, dadurch gekennzeichnet, daß die beiden Holme (10) mit ihren V-förmig angeordneten, gegeneinander gerichteten Reihen (11, 12) von Zinken (13) spiegelsymmetrisch zu der zwischen den Holmen (10) verlaufenden Längsmittelebene (L) angeordnet sind.

5. Vorrichtung nach einem der Ansprüche 1 bis 4, dadurch gekennzeichnet, daß die Winkelhalbierenden (W) der von den vorzugsweise geraden Zinken (13) des einen Holmes (10) jeweils gebildeten spitzen Winkel mit denen der von den Zinken (13) des anderen Holmes (10) gebildeten Winkeln übereinstimmen.

6. Vorrichtung nach einem der Ansprüche 1 bis 5, dadurch gekennzeichnet, daß die Winkelhalbierenden (W) der von den Zinken (13) der Holme (10) jeweils gebildeten spitzen Winkel mit den Holmen (10) in einer gemeinsamen Ebene liegen, zu der die Längsmittelebene (L) rechtwinklig angeordnet ist.

7. Vorrichtung nach einem der Ansprüche 1 bis 6, dadurch gekennzeichnet, daß der Abstand zwischen jeweils einander in Reihe benachbarter Zinken (13) größer als die seitliche Ausdehnung dieser Zinken ist, zum Beispiel das Fünffache bis Zehnfache, insbesondere das Siebenfache oder Achtfache des Zinkendurchmessers oder der Zinkenbreite beträgt.

8. Vorrichtung nach einem der Ansprüche 1 bis 7, dadurch gekennzeichnet, daß zwischen den freien Enden der einander vorzugsweise genau in einer gemeinsamen Ebene gegenüber liegenden Zinken (13) eines Halters (3) ein Zwischenraum (16) vorgesehen ist, der kleiner ist, als es der geringsten Breite einer Platte (2) entspricht, und daß die Abmessung dieses Zwischenraumes (16) vorzugsweise etwa ein Sechstel bis ein Viertel, insbesondere ein Fünftel des Abstandes der beiden parallelen Holme (10) beträgt.

9. Vorrichtung nach einem der Ansprüche 1 bis 8, dadurch gekennzeichnet, daß der Abstand der Holme (10) verstellbar ist.

10. Vorrichtung nach einem der Ansprüche 8 und 9, dadurch gekennzeichnet, daß die Schenkel (15a, 15b) des stirnseitigen Anschlages (15) einen stumpfen Winkel miteinander einschließen und daß zwischen den beiden Stellen (15c), an denen die Schenkel (15a, 15b) jeweils unter spitzem Winkel von dem Träger (14) abgehen, vorzugsweise eine geradlinige Verbindung (15d) der beiden Schenkel (15a, 15b) etwa von der Länge vorgesehen ist, die dem Abstand der freien Enden der Zinken (13) etwa entspricht oder diesen übertrifft und die kleiner als die Breite der kleinsten zu haltenden Platte ist.

11. Vorrichtung nach einem der Ansprüche 1 bis 10, dadurch gekennzeichnet, daß zwischen dem Träger und der ihm unmittelbar benachbarten ersten Zinke ein dem Abstand zwischen den einzelnen Zinken etwa entsprechender oder kleinerer Abstand vorgesehen ist und daß die Schenkel des stirnseitigen Anschlages in dem Bereich zwischen dem Träger und dieser ersten Zinke, insbesondere etwa auf der Mitte in diesem Zwischenraum enden, dabei insbesondere den Holm berühren und mit diesem vorzugsweise verbunden sind.

12. Vorrichtung nach einem der Ansprüche 1 bis 11, dadurch gekennzeichnet, daß der stirnseitige Anschlag (15) im Bereich des Trägers (14) quer zu der zwischen dem Träger (14) und den Holmen (10) aufgespannten Ebene eine größere Breite (b) als der Träger (14) und die Holme (10) hat und seine Breite etwa dem lichten Abstand (a) der jeweils V-förmig auseinander laufenden Zinken (13) zweier Zinkenreihen (11, 12) eines Holmes (10) an ihren freien Enden entspricht.

13. Vorrichtung nach Anspruch 12, dadurch gekennzeichnet, daß sich die Breite (b) des stirnseitigen Anschlages (15) und insbesondere die Breite der unter stumpfem Winkel zueinander stehenden Schenkel (15a, 15b) gegen die Holme (10) hin vermindert, vorzugsweise unter dem Winkel, unter welchem jeweils die V-förmig zueinander angeordneten Zinken (13) zueinander stehen, so daß der stirnseitige Anschlag (15) die Projektion der Reihen (11, 12) der Zinken (13) stirnseitig vor dem Träger (14) abschließt und die Ränder der Schenkel (15a, 15b) des stirnseitigen Anschlages (15) jeweils etwa in der von den Zinken (13) einer Reihe (11, 12) gebildeten Ebene verlaufen.

14. Vorrichtung nach einem der Ansprüche 1 bis 13, dadurch gekennzeichnet, daß der Träger (14) die beiden von ihm abgehenden parallelen Holme (10) beidseits überragt und insbesondere in dem Bereich des Überstandes (17) Befestigungs- oder Kupplungsstellen, zum Beispiel Lochungen (18), zum Verbinden mit Vorschubmitteln für den Transport der Halter (3) und der Platten (2) aufweist.

15. Vorrichtung nach einem der vorstehenden Ansprüche, dadurch gekennzeichnet, daß als Vorschubmittel für eine Vielzahl von in gleichbleibendem Abstand zueinander daran angeordnete Halter (3) endlos umlaufendes Zugelement, vorzugsweise Ketten (4), Bänder oder dergleichen, vorgesehen ist, zu dessen Längserstreckung und Bewegungsrichtung die Holme (10) der Halter (3) etwa rechtwinklig nach außen abstehen, wobei die freien, dem Träger (14) abgewandten Enden der Holme (10) von den Zugelementen oder Ketten (4) weggerichtet sind.

16. Vorrichtung insbesondere nach einem der vorstehenden Ansprüche, dadurch gekennzeichnet, daß seitlich bzw. in horizontaler Richtung quer zur Vorschubrichtung neben dem endlos umlaufenden Vorschubmittel mit daran befestigten oder angekuppelten Haltern (3) eine Beschichtungs- oder Belackungsstation (9) angeordnet ist und daß jeweils in einem eine vertikale Vorschubrichtung aufweisenden Förderbereich des umlaufenden Vorschubmittels Übergabestationen (8), vorzugsweise Rollenbahnen (21) mit jeweils V-förmig zueinander angeordneten Paaren von antreibbaren Rollen (22) zum Entnehmen der Platten (2) aus den Haltern (3) und außerhalb des von den Haltern (3) durchlaufenen Bereiches Querförderer (23) vorgesehen sind, mit denen die Platten (2) oder Leiterplatten seitlich versetzt und der Beschichtungs- oder Belackungsstation (9) zuführbar und nach dem Beschichten oder Lackieren in umgekehrter Weise einer Übergabestation (8) und dort einem Halter (3) zuführbar sind.

17. Vorrichtung nach Anspruch 16, dadurch gekennzeichnet, daß als Querförderer (23) querfördernde, zwischen die Rollen (22) der Rollenbahnen (20, 21) passende und in den Zwischenräumen unter dar Rollenniveau absenkbare und über das Rollenniveau anhebbare Hubbänder (25) vorgesehen sind, deren Fördertrum (25a) bis zwischen die Rollen eines vor und oder hinter der Belackungsstation (9) angeordneten Rollenförderers (20) reichen.

18. Vorrichtung nach Anspruch 16, dadurch gekennzeichnet, daß als Querförderer (23) mit ihren Zinken (26) zwischen die einzelnen Rollen (22) der Rollenbahnen (20, 21) an der Übergabestation (8) und an der Belackungsstation (9) passende Hub- und Schwenkrechen (27) vorgesehen sind, die an einer zwischen diesen beiden parallelen Rollenbahnen (20, 21) angeordneten Hubsäule (28) angeordnet, unter das Niveau der Rollen (22) absenkbar und über das Niveau der Rollen anhebbar und in angehobener Position um wenigstens 180° um eine vertikale Achse verdrehbar sind, und daß die Zinken (26) vorzugsweise in ihrer Längsrichtung konkav gekrümmt oder unter einem stumpfen Winkel gebogen sind.

19. Vorrichtung nach Anspruch 18, dadurch gekennzeichnet, daß der Hub- und Schwenkrechen (27) ein Doppelrechen ist, bei welchen von einem an der Hub- und Schwenksäule (28) angeordneten Tragprofil (29) nach den beiden einander gegenüberliegenden Seiten in vorzugsweise symmetrischer Anordnung Zinken (26) abstehen, die jeweils in die Zwischenräume der Rollen (22) der Rollenbahnen (20, 21) reichen.

20. Vorrichtung nach einem der Ansprüche 16 bis 19, dadurch gekennzeichnet, daß die innerhalb der Rollenbahnen (20, 21) jeweils V-förmig zueinander geneigten Rollen (22) auf einer entsprechend V-förmigen Achse (30) gelagert sind, eine der beiden Rollen angetrieben und die andere mit der angetriebenen Rolle über ein elastisches Verbindungselement, insbesondere eine Spiralfeder (31), in Drehrichtung gekuppelt ist.

21. Vorrichtung nach einem der Ansprüche 16 bis 20, dadurch gekennzeichnet, daß der Neigungswinkel der V-förmig angeordneten Transportrollen (22) sowie der Zinken (26) des Hub- und Schwenkrechens und die Neigungswinkel der von den beiden Holmen (10) insbesondere geradlinig aufeinander zulaufenden Zinken (13) miteinander etwa übereinstimmen.

22. Vorrichtung nach einem der Ansprüche 15 bis 21, dadurch gekennzeichnet, daß das Vorschubelement, insbesondere die Kette (4), taktförmig weiterbewegbar ist und jeweils ein Halter (3) in der Übergabestation (8) zu der Belackungsstation (9) und in der Übergabestation (8) von der Belackungsstation (9) wieder zurück im Bereich der ab- und zuführenden Rollenbahn (21) angeordnet ist, wobei die Eingabe- und Ausgabemittel (32) ortsfest und bezüglich ihres Niveaus unveränderlich angeordnet sind.

23. Vorrichtung nach einem der Ansprüche 16 bis 22, dadurch gekennzeichnet, daß an der Übergabestation (8) zu der Belackungsstation (9) das Entladegerät (24) für beschichtete Platten (2) und vorzugsweise eine Sensoreinrichtung (33), insbesondere eine optische Sensoreinrichtung (33) angeordnet ist, die das Entladegerät (24) ansteuert, wenn eine Platte (2) beidseitig beschichtet ist und die den Querförderer (23) zu der Belackungsstation (9) ansteuert, wenn die Platte (2) einseitig beschichtet ist.

24. Vorrichtung nach einem der Ansprüche 1 bis 23, dadurch gekennzeichnet, daß der aufwärts, insbesondere vertikal aufwärts führende Bereich des Vorschubelementes, der sich in Förderrichtung hinter der Belackungsstation (9) befindet, eine Zuluft- und Absaugeinrichtung zum Belüften und Vortrocknen der beschichteten Platten 2 aufweist.

25. Vorrichtung nach einem der Ansprüche 1 bis 24, dadurch gekennzeichnet, daß ein Teil des Förderweges des Vorschubelementes als Trocknungsstation ausgebildet ist, vorzugsweise der sich an den aufwärts gerichteten Teil anschließende, insbesondere horizontal und entgegengesetzt zur Förderrichtung in der Belackungsstation (9) bewegbare Teil des Vorschubmittels.

26. Vorrichtung nach Anspruch 25, dadurch gekennzeichnet, daß der in Förderrichtung im Anschluß an die Trocknungsstation (6) angeordnete, vorzugsweise wieder abwärts, insbesondere vertikal abwärts zu der Übergabestation (8) führende Teil des Vorschubelementes als Kühl- und Nachtrocknungsstrecke (7) ausgebildet ist, an deren Ende die Entnahme- oder Ausgabemittel (32) und gegebenenfalls der Sensor (33) angeordnet sind.

27. Vorrichtung nach einem der Ansprüche 1 bis 26, dadurch gekennzeichnet, daß die Halter (3) des Vorschubelementes an dessen zwischen der abwärts gerichteten Förderstrecke und der aufwärts gerichteten Förderstrecke befindlichen, parallel zu dem Förderweg in der Belackungsstation (9) bewegbaren Untertrum leer sind.

28. Vorrichtung nach einem der Ansprüche 16 bis 27, aadurch gekennzeichnet, daß als Ein- und Ausgabemittel (32) für die Platten jeweils eine in horizontaler Richtung fördernde, zwischen die Reihen der Zinken (13) des Halters (3) eingreifende Eingreif-Rollenbahn mit vorzugsweise in stumpfem Winkel zueinander stehenden, angetriebenen Rollen (37) stationär vorgesehen ist, wobei diese Rollen (37) jeweils unterhalb beziehungsweise oberhalb der seitlichen Abstände zwischen einzelnen benachbarten Zinken (13) des Halters (3) angeordnet sind u. ein mittlerer Rollenträger (38) unterhalb beziehungsweise oberhalb des zwischen den freien Enden der Zinken (13) vorhandenen Zwischenraumes (16) der Halter (3) angeordnet ist, so dass die Kalter (3) in vertikaler Richtung kammartig von oben nach unten oder von unten nach oben durch die Eingreif-Rollenbahn bewegbar sind und bei ihrer Abwärtsbewegung eine zwischen den Zinken (13) befindliche Platte (2) auf der Eingreif-Rollenbahn ablegen beziehungsweise bei ihrem Durchgang von unten nach oben eine auf der Eingreif-Rollenbahn liegende Platte (2) mitnehmen.

29. Vorrichtung nach einem der Ansprüche 16 bis 28, dadurch gekennzeichnet, daß der Lack-Gießvorhang (39) oder -Sprühbereich der Belackungsstation (9) schmaler als der jeweils zu beschichtende Bereich der Platte (2) ist und die Platte (2) an diesen in Förderrichtung beidseitigen Rändern (2a) gegenüber der Lackzuführung abgeschirmt sind.

30. Vorrichtung nach einem der Ansprüche 16 bis 29, dadurch gekennzeichnet, daß die Belackungsstation zwei im Bereich eines Gießvorhanges oder einer Gießsprüheinrichtung unterbrochene, sich in Förderrichtung fortsetzende Rollenförderer oder Förderbänder (41) zum Transport der Platte (2) durch die Belackungsstation (9) hindurch aufweist.

31. Vorrichtung nach einem der Ansprüche 16 bis 30, dadurch gekennzeichnet, daß die Rollen der Rollenbahn oder die beiden Förderbänder (41) der Belackungsstation (9) in Längsrichtung unterteilt und ihre parallelen Hälften V-förmig unter stumpfem Winkel zueinander angeordnet sind.

32. Vorrichtung nach Anspruch 31, dadurch gekennzeichnet, daß der V-Winkel der parallelen Hälften der Förderer (41) der Belackungsstation (9) dem der Zuführ-Rollenbahn und der Zinken (26) des Schwenkrechens (27) oder dergleichen und vorzugsweise dem Winkel zwischen den jeweils gegeneinander gerichteten Zinken (13) des Halters (3) entspricht.

**Fig. 5**

EP 0 421 931 A1

**Fig. 6**

**Fig. 7**

EP 0 421 931 A1

Fig. 8

EP 0 421 931 A1

_Fig. 9_

Fig. 10

**Fig. 11**

EP 0 421 931 A1

Fig. 12

Fig. 13

EP 0 421 931 A1

_Fig. 14._

26

Europäisches
Patentamt

**EUROPÄISCHER
RECHERCHENBERICHT**

Nummer der Anmeldung

**EP 90 81 0740**

## EINSCHLÄGIGE DOKUMENTE

| Kategorie | Kennzeichnung des Dokuments mit Angabe, soweit erforderlich, der maßgeblichen Teile | Betrifft Anspruch | KLASSIFIKATION DER ANMELDUNG (Int. Cl.5) |
|---|---|---|---|
| A | EP-A-0 252 882 (CIBA-GEIGY) <br> * Spalte 6, Zeile 28 - Seite 7, Zeile 5 * * Spalte 7, Zeilen 39 - 61; Anspruch 1; Figuren 1, 2, 4, 7 * <br> — — — | 1,14-16, 24-27 | H 05 <br> K 13/00 |
| D,A | FR-A-2 439 734 (RIVES GERARD) <br> * Ansprüche 1-4; Figuren 1-5 * <br> — — — | 1 | |
| D,A | EP-A-0 312 498 (CIBA-GEIGY) <br> * Spalte 10, Zeile 62 - Spalte 11, Zeile 37; Anspruch 1; Figuren 1, 19, 20 * <br> — — — — | 1 | |

| RECHERCHIERTE SACHGEBIETE (Int. Cl.5) |
|---|
| H 05 K <br> B 65 G |

Der vorliegende Recherchenbericht wurde für alle Patentansprüche erstellt

| Recherchenort | Abschlußdatum der Recherche | Prüfer |
|---|---|---|
| Den Haag | 10 Januar 91 | RIEUTORT A.S. |

KATEGORIE DER GENANNTEN DOKUMENTE

X : von besonderer Bedeutung allein betrachtet
Y : von besonderer Bedeutung in Verbindung mit einer anderen Veröffentlichung derselben Kategorie
A : technologischer Hintergrund
O : nichtschriftliche Offenbarung
P : Zwischenliteratur
T : der Erfindung zugrunde liegende Theorien oder Grundsätze

E : älteres Patentdokument, das jedoch erst am oder nach dem Anmeldedatum veröffentlicht worden ist
D : in der Anmeldung angeführtes Dokument
L : aus anderen Gründen angeführtes Dokument

& : Mitglied der gleichen Patentfamilie, übereinstimmendes Dokument